# EUROPÄISCHE PATENTSCHRIFT

(11) **EP 0 463 015 B1**
(45) Veröffentlichungstag und Bekanntmachung des Hinweises auf die Patenterteilung: **28.07.1993**
(21) Anmeldenummer: 90904346.5
(22) Anmeldetag: 14.03.1990
(51) Int. Cl.: G03F 7/32, G03C 1/805, G03C 8/36

(54) **LICHTEMPFINDLICHES AUFZEICHNUNGSELEMENT MIT EINER AUFZEICHNUNGSSCHICHT UND EINER DECKSCHICHT UNTERSCHIEDLICHER LÖSLICHKEITSEIGENSCHAFTEN SOWIE VERFAHREN ZU SEINER ENTWICKLUNG IN EINEM ARBEITSGANG**
PHOTOSENSITIVE PRINTING COMPONENT WITH A PRINTING LAYER AND A COVERING LAYER OF DIFFERING SOLUBILITY AND A PROCESS FOR DEVELOPING IT IN ONE WORKING CYCLE
ELEMENT PHOTOSENSIBLE D'ENREGISTREMENT AVEC UNE COUCHE D'ENREGISTREMENT ET UNE COUCHE DE COUVERTURE AYANT DES SOLUBILITES DIFFERENTES, ET PROCEDE DE DEVELOPPEMENT EN UNE SEULE OPERATION

(30) Priorität: 17.03.1989 DE 3908763
(43) Veröffentlichungstag der Anmeldung: 02.01.1992
(73) Patentinhaber: BASF Aktiengesellschaft, 67063 Ludwigshafen (DE)
(72) Erfinder: TELSER, Thomas, D-6940 Weinheim (DE); HUEMMER, Wolfgang, D-6703 Limburgerhof (DE); KURTZ, Karl-Rudolf, D-6900 Heidelberg (DE)
(86) Internationale Anmeldenummer: EP9000407
(87) Internationale Veröffentlichungsnummer: WO9011550

(56) Entgegenhaltungen:
- EP-A- 0 055 807
- EP-A- 0 059 385
- EP-A- 0 104 954
- EP-A- 0 161 870
- EP-A- 0 162 691
- EP-A- 0 195 336
- EP-A- 0 251 049
- EP-A- 0 291 879
- US-A- 4 716 098

## Beschreibung

Die vorliegende Erfindung betrifft ein neues lichtempfindliches Aufzeichnungselement mit einem dimensionsstabilen Träger (A), einer photopolymerisierbaren reliefbildenen Aufzeichnungsschicht (B), welche aus einer einzigen Schicht (B) oder aus mindestens zwei Einzelschichten (B) besteht, und einer an der Oberfläche von (B) fest haftenden optisch transparenten Deckschicht (C). Das neue lichtempfindliche Aufzeichnungselement dient der Herstellung einer flexographischen Reliefdruckplatte.

Außerdem betrifft die vorliegende Erfindung neue Verfahren zur Herstellung flexographischer Reliefdruckplatten aus diesem neuen oder aus bekannten lichtempfindlichen Aufzeichnungselementen.

Lichtempfindliche Aufzeichnungselemente mit einem dimensionsstabilen Träger (A), einer photopolymerisierbaren reliefbildenden Aufzeichnungsschicht (B), welche aus einer einzigen Schicht (B) oder aus mindestens zwei Einzelschichten (B) besteht, und mit einer an der Oberfläche von (B) fest haftenden optisch transparenten Deckschicht (C) sind beispielsweise aus der US-A-2 760 863, der US-A-4 323 636, der US-A-4 369 246, der US-A-4 323 637, der DE-B-21 23 702, der US-A-3 990 897 (DE-A-24 44 118), der US-A-4 162 919 (DE-A-24 56 439), der DE-A-28 15 678, der DE-A-28 23 300, der DE-A-28 30 622, der DE-A-29 39 989, der US-A-4 320 188 (DE-A-29 42 183), der DE-A-30 12 841, der EP-B-0 084 851 (US-A-4 460 675, US-A-4 427 759, GB-B-1 366 769), EP-A-0 185 337 (US-A-4 622 088), der EP-A-0 133 265 und der EP-A-0 183 552 bekannt oder werden in den älteren deutschen Patentanmeldungen P 37 36 980.6, P 38 03 457.3 und P 38 33 650.2 beschrieben.

Dieser Fülle des seit dem Jahre 1956 bekannten Standes der Technik läßt sich klar entnehmen, daß unabhängig davon, ob die bildmäßig belichtete reliefbildende Aufzeichnungsschicht (B) der bekannten lichtempfindlichen Aufzeichnungselemente mit organischen oder wäßrigen Lösungsmitteln entwickelt wird, die an der Oberfläche der betreffenden Aufzeichnungsschicht (B) fest anhaftende optisch transparente Deckschicht (C) stets in den zur Entwicklung jeweils verwendeten Lösungsmitteln löslich oder quellbar ist, so daß sie zusammen mit den nicht belichteten und daher nach wie vor in den Lösungsmitteln löslichen oder quellbaren Bereichen der Aufzeichnungsschicht (B) weggewaschen wird. Wäre dies nicht der Fall, machte dies einen gesonderten Arbeitsgang bei der Entwicklung der bekannten bildmäßig belichteten Aufzeichnungselemente notwendig, was aus leicht einsehbaren Gründen der Wirtschaftlichkeit, des Zeitaufwandes und des apparativen Mehraufwandes bislang immer vermieden worden ist.

Zwar werden in zahlreichen der vorstehend beispielhaft genannten Patentschriften sowohl in organischen als auch in wäßrigen Lösungsmitteln lösliche oder quellbare Deckschichten (C) in einem Atemzug genannt, indes ist kein Beispiel bekannt geworden, in welchem eine optisch transparente Deckschicht (C) verwendet worden wäre, welche in dem jeweiligen Lösungsmittel für die bildmäßig belichtete reliefbildende Aufzeichnungsschicht (B) unlöslich oder nicht quellbar gewesen wäre.

So geht zwar beispielsweise aus der EP-A-0 059 385 ein lichtempfindliches Aufzeichnungselement mit einer photopolymerisierbaren reliefbildenden Aufzeichnungsschicht (B) hervor, welches der Herstellung flexographischer Reliefdruckplatten dient, indes wird hierin kein Hinweis darauf gegeben, diese Aufzeichnungsschicht (B) mit einer optisch transparenten Deckschicht (C) völlig anderer Löslichkeit zu kombinieren.

Aus alledem ist zu schließen, daß die Fachwelt ein lichtempfindliches Aufzeichnungselement, dessen photopolymerisierbare reliefbildende Aufzeichnungsschicht (B) und dessen an der Oberfläche von (B) fest anhaftende optisch transparente Deckschicht (C) unterschiedliche Löslichkeitseigenschaften aufweisen, grundsätzlich als nicht praxisgerecht angesehen hat.

Dies wird auch nicht durch die Lehre der EP-A-0 162 691 geändert, denn hieraus geht kein lichtempfindliches Aufzeichnungselement für die Herstellung einer flexographischen Reliefdruckplatte hervor, sondern es wird nur ein Aufzeichnungselement beschrieben, das der Herstellung einer lithographischen Flachdruckplatte dient. Bei seiner Aufzeichnungsschicht, welche eine Dicke von höchstens bis zu 3,23 µm haben soll, handelt es sich um eine photovernetzbare, indes nicht photopolymerisierbare, Diazoschicht, wie sie üblicherweise auf dem Gebiet lithographischer Flachdruck- oder Offsetdruckplatten verwendet wird. Diese Diazoschicht wird nach ihrer bildmäßigen Belichtung mit Wasser entwickelt. Sie ist bedeckt von einer Deckschicht aus O-epoxyalkylierten Tetrakis-(hydroxyphenyl)ethan-Harzen, welche zwar oleophil, aber dennoch wasserdurchlässig ist. Bei der Entwicklung mit Wasser werden die Teile der Deckschicht, welche den unbelichteten Bereichen der Diazoschicht aufliegen, zusammen mit diesen entfernt. Die Teile der Deckschicht, welche den belichteten Bereichen der Diazoschicht aufliegen, werden hierbei nicht weggewaschen, sondern verbleiben auf diesen Bereichen. Hierdurch wird die Differenzierung zwischen der durch die Entwicklung bildmäßig freigelegten hydrophilen Trägeroberfläche (den Nichtbildbereichen) und den oleophilen Bildbereichen verbessert, was die Druckeigenschaften der lithographischen Flachdruck- oder Offsetdruckplatte verbessert.

Bei flexographischen Reliefdruckplatten dagegen, deren druckende Reliefschicht besonders dick ausgestaltet ist, ist eine solche offsettypische Differenzierung der druckenden Oberfläche weder vorgesehen noch erwünscht. Außerdem müssen aufgrund der Dicke der photopolymerisierbaren Aufzeichnungsschicht (B) der lichtempfindlichen Aufzeichnungselemente für die Herstellung flexographischer Reliefdruckplatten bei deren Entwicklung erheblich größere Mengen am Material weggewaschen werden, als dies bei der Entwicklung von Aufzeichnungselementen für die Herstellung von lithographischen Offsetdruckplatten jemals der Fall sein kann. Diese beiden grundlegenden Unterschiede zwischen dem Gebiet der flexographischen Reliefdruckplatten einerseits und dem der lithographischen Offsetdruckplatten andererseits führen dazu, daß Problemlösungen des einen Gebietes für das andere Gebiet nicht relevant sind und von der Fachwelt auch nicht in Betracht gezogen werden: So wird man sich die Herstellung einer flexographischen Reliefdruckplatte, bei welcher ohnehin schon viel Material wegzuwaschen ist, nicht noch dadurch weiter erschweren wollen, daß man zusätzlich noch eine im Entwicklerlösungsmittel unlösliche Deckschicht (C) auf der photopolymerisierbaren reliefbildenden Aufzeichnungsschicht (B) aufbringt.

Zweck des Aufbringens einer optisch transparenten Deckschicht (C) auf einer photopolymerisierbaren reliefbildenden Aufzeichnungsschicht (B) ist es, die für die bildmäßige Belichtung verwendete Negativvorlage am Festkleben an der Oberfläche der photopolymerisierbaren reliefbildenden Aufzeichnungsschicht (B) zu hindern. Außerdem dient die optisch transparente Deckschicht (C) dem Schutz der photopolymerisierbaren reliefbildenden Aufzeichnungsschicht (B) gegen die inhibierende Wirkung des Luftsauerstoffs und/oder die Ablagerung von Schmutzpartikeln.

Üblicherweise liegt in den bislang bekannten lichtempfindlichen Aufzeichnungselementen der optisch transparenten Deckschicht (C) eine optisch transparente oder nicht transparente Deckfolie (D) auf, welche bekanntermaßen vor der bildmäßigen Belichtung von der optisch transparenten Deckschicht (C) abgezogen wird. Hierzu muß die optisch transparente Deckschicht (C) eine genau abgestufte Haftungsdifferenzierung aufweisen, damit sie beim Abziehen der Deckfolie (D) an der Oberfläche der photopolymerisierbaren reliefbildenden Aufzeichnungsschicht (B) fester haftet als an der Oberfläche der Deckfolie (D).

Des weiteren muß die optisch transparente Deckschicht (C) eine hohe Sperrwirkung gegenüber den leicht diffundierenden und/oder leicht verdampfenden niedermolekularen Bestandteilen der photopolymerisierbaren reliefbildenden Aufzeichnungsschicht (B) haben, damit diese niedermolekularen Bestandteile nicht aus der Aufzeichnungsschicht (B) entweichen und so deren anwendungstechnisches Eigenschaftsprofil und das der Deckschicht (C) nicht in nachteiliger Weise ändern. Beispielesweise kann bei zu hoher Verträglichkeit der niedermolekularen Bestandteile der photopolymerisierbaren reliefbildenden Aufzeichnungsschicht (B) mit der optisch transparenten Deckschicht (C) eine so große Menge an beispielsweise photopolymerisierbaren olefinisch ungesättigten Monomeren und Photopolymerisationsinitiatoren in die optisch transparente Deckschicht (C) migrieren, daß diese selbst bis zu einem gewissen Grad photopolymerisierbar wird und nach der bildmäßigen Belichtung der reliefbildenden Aufzeichnungsschicht (B) nicht mehr länger von deren belichteten Bereichen weggewaschen werden kann. Andererseits können so große Mengen an niedermolekularen Zusatzstoffen wie Weichmacher, Farbstoffe, Antioxidantien oder Antiozonantien in die optisch transparente Deckschicht (C) eindiffundieren, daß diese sich in ihrer optischen Transparenz, ihrer Reißfestigkeit, ihrer Flexibilität und/oder ihrer genau abgestuften Haftungsdifferenzierung unvorteilhaft verändert. Das Eindiffundieren all dieser niedermolekularen Bestandteile kann aber auch den Verlust der Sperrwirkung der optisch transparenten Deckschicht (C) gegenüber Luftsauerstoff zur Folge haben. Gerade der Verlust der Flexibilität, der Reißfestigkeit und der guten Haftung auf der photopolymerisierbaren reliefbildenden Aufzeichnungsschicht (B) führt häufig zum Reißen und/oder zum Aufwerfen der optisch transparenten Deckschicht (C). Dies ist insbesondere dann von großem Nachteil, wenn die lichtempfindlichen Aufzeichnungselemente vor ihrer bildmäßigen Belichtung bereits auf Druckzylinder aufgespannt werden sollen.

Es ist bis zu einem gewissen Grad möglich, bei einem gegebenen bekannten lichtempfindlichen Aufzeichnungselement diese Probleme und Nachteile durch Variation der optisch transparenten Deckschicht (C) zu umgehen. Bislang war aber die Auswahl geeigneter optisch transparenter Deckschichten (C) nach Ansicht der Fachwelt dadurch empfindlich eingeschränkt, daß in den lichtempfindlichen Aufzeichnungselementen nur solche optisch transparente Deckschichten (C) und photopolymerisierbare reliefbildende Aufzeichnungsschichten (B) miteinander kombiniert werden sollten, welche in den gleichen Lösungsmitteln löslich oder quellbar sind. Die Erfüllung dieser als grundsätzlich erachteten Maßgabe setzt indes voraus, daß die Bestandteile der optisch transparenten Deckschichten (C) in ihren physikalisch chemischen Eigenschaften den Bestandteilen, insbesondere den polymeren Bindemitteln, der photopolymerisierbaren reliefbildenden Aufzeichnungsschichten (B) ähnlich sind, was dazu beiträgt, die vorstehend erwähnten unerwünschten Diffusionsvorgänge hervorzurufen und/oder zu verstärken, weil in beiden Schichten (B) und (C) eine chemisch ähnliche Umgebung vorliegt und zwischen den Schichten ein Konzentrationsgradient herrscht.

Aufgabe der vorliegenden Erfindung ist es, ein neues lichtempfindliches Aufzeichnungselement mit einem dimensionsstabilen Träger (A), einer photopolymerisierbaren reliefbildenden Aufzeichnungsschicht (B), welche aus einer einzigen Schicht (B) oder aus mindestens zwei Einzelschichten (B) besteht, und einer an der Oberfläche von (B) fest haftenden optisch transparenten Deckschicht (C) zu finden. Das neue lichtempfindliche Aufzeichnungselement soll der Herstellung einer flexographischen Reliefdruckplatte dienen und soll die vorstehend geschilderten Nachteile des Standes der Technik nicht mehr länger aufweisen. Des weiteren war es die Aufgabe der vorliegenden Erfindung, neue Verfahren zur Herstellung flexographischer Reliefdruckplatten aus lichtempfindlichen Aufzeichnungselementen zu finden, welche das Auswaschen (Entwickeln) der bildmäßig belichteten Aufzeichnungselemente in einem Arbeitsgang gestatten.

Überraschenderweise konnte die Aufgabe der vorliegenden Erfindung durch die Kombination einer photopolymerisierbaren reliefbildenden Aufzeichnungsschicht (B), welche aus einer einzigen Schicht (B) oder aus mindestens zwei Einzelschichten (B) besteht und in welcher bei der bildmäßigen Belichtung mit aktinischem Licht eine Löslichkeitsdifferenzierung zwischen ihren belichteten und unbelichteten Bereich eintritt, so daß ihre unbelichteten Bereiche mit einem bestimmten Lösungsmittel ausgewaschen werden können, mit einer optisch transparenten Deckschicht (C), welche in dem betreffenden Lösungsmittel nicht löslich oder quellbar ist, gelöst werden. Im Hinblick darauf, daß diese Kombination von der Fachwelt generell als untauglich angesehen worden ist, war die Lösung der erfindungsgemäßen Aufgabe um so mehr überraschend.

Demgemäß handelt es sich bei dem Gegenstand der vorliegenden Erfindung um ein lichtempfindliches Aufzeichnungselement für die Herstellung einer flexographischen Reliefdruckplatte mit einem dimensionsstabilen Träger (A), einer 0,1 bis 7 mm dicken photopolymerisierbaren reliefbildenden Aufzeichnungsschicht (B), welche aus einer einzigen Schicht (B) oder aus mindestens zwei Einzelschichten (B) besteht und in welcher bei der bildmäßigen Belichtung mit aktinischem Licht eine Löslichkeitsdifferenzierung zwischen ihren belichteten und unbelichteten Bereichen eintritt, so daß ihre unbelichteten Bereiche insgesamt oder die unbelichteten Bereiche ihrer obersten Einzelschicht (B) mit einem bestimmten Lösungsmittel ausgewaschen (entwickelt) werden können, und einer an der Oberfläche von (B) fest haftenden optisch transparenten Deckschicht (C), welches dadurch gekennzeichnet ist, daß die optisch transparente Deckschicht (C) in dem Lösungsmittel für die unbelichteten Bereiche der Aufzeichnungsschicht (B) nicht löslich oder quellbar ist.

Ein weiterer Gegenstand der vorliegenden Erfindung ist ein neues Verfahren zur Herstellung einer flexographischen Reliefdruckplatte, welches dadurch gekennzeichnet ist, daß man hierbei ein lichtempfindliches Aufzeichnungselement der vorstehend genannten Art verwendet und daß man das Auswaschen (Entwickeln) des bildmäßig belichteten Aufzeichnungselements mit Hilfe einer Emulsion in einem Arbeitsgang durchführt.

Das neue lichtempfindliche Aufzeichnungselement für die Herstellung einer flexographischen Reliefdruckplatte mit einem dimensionsstabilen Träger (A), einer photopolymerisierbaren reliefbildenden Aufzeichnungsschicht (B), welche aus einer einzigen Schicht (B) oder aus mindestens zwei Einzelschichten (B) besteht, und einer an der Oberfläche von (B) fest haftenden optisch transparenten Deckschicht (C) wird im folgenden der Kürze halber als "erfindungsgemäßes Aufzeichnungselement" bezeichnet.

Das neue Verfahren zur Herstellung einer flexographischen Reliefdruckplatte mit einer photopolymerisierten Reliefschicht aus dem erfindungsgemäßen Aufzeichnungselement wird im folgenden kurz als "erfindungsgemäßes Verfahren" bezeichnet. Das erfindungsgemäße Verfahren kann auch der Herstellung einer flexographischen Reliefdruckplatte aus einem bekannten lichtempfindlichen Aufzeichnungselement dienen.

Die beiden erfindungsgemäß wesentlichen Bestandteile des erfindungsgemäßen Aufzeichnungselements sind die photopolymerisierbare reliefbildende Aufzeichnungsschicht (B), welche aus einer einzigen Schicht (B) oder aus mindestens zwei Einzelschichten (B) bestehen kann und in welcher bei der bildmäßigen Belichtung mit aktinischem Licht eine Löslichkeitsdifferenzierung zwischen ihren belichteten und unbelichteten Bereichen eintritt, so daß ihre unbelichteten Bereiche insgesamt oder die unbelichteten Bereiche ihrer obersten Einzelschicht (B) mit einem bestimmten Lösungsmittel ausgewaschen (entwickelt) werden können, sowie die optisch transparente Deckschicht (C), welche in diesem betreffenden Lösungsmittel nicht löslich oder quellbar ist.

Bei dieser neuen Kombination einer photopolymerisierbaren reliefbildenden Aufzeichnungsschicht (B) und einer optisch transparenten Deckschicht (C), welche unterschiedliche Löslichkeitseigenschaften aufweisen, können die photopolymerisierbare reliefbildende Aufzeichnungsschicht (B) oder die oberste Einzelschicht (B) bzw. deren nicht belichteten Bereiche in Wasser oder wäßrigen Lösungsmitteln löslich oder quellbar sein, wogegen die optisch transparente Deckschicht (C) in organischen Lösungsmitteln löslich oder quellbar ist. Andererseits kann die optisch transparente Deckschicht (C) in Wasser oder wäßrigen Lösungsmitteln löslich oder quellbar sein, wogegen die photopolymerisierbare reliefbildende Aufzeichnungsschicht (B) oder die oberste Einzelschicht (B) bzw. deren nicht belichteten Bereiche in organischen Lösungsmitteln löslich oder quellbar sind.

Sowohl die in organischen Lösungsmitteln lösliche oder quellbare photopolymerisierbare reliefbildende Aufzeichnungsschicht (B) oder oberste Einzelschicht (B) als auch die entsprechende in Wasser oder wäßrigen Lösungsmitteln lösliche oder quellbare bestehen bekanntermaßen aus mindestens einem in den betreffenden Lösungsmitteln löslichen oder quellbaren Polymeren als Bindemittel (b₁), mindestens einem Photopolymerisationsinitiator (b₂), mindestens einem olefinisch ungesättigten photopolymerisierbaren Monomeren, welches mit dem oder den Polymeren (b₁) verträglich ist, und mindestens einem Hilfstoff (b₄).

Beispiele geeigneter mit Wasser oder wäßrigen Lösungsmitteln entwickelbarer photopolymerisierbarer reliefbildender Aufzeichnungsschichten (B) oder oberster Einzelschichten (B) zur Verwendung in dem erfindungsgemäßen Aufzeichnungselement enthalten als in Wasser lösliche oder quellbare Bindemittel (b₁) Copolymerisate des Ethylens mit (Meth)Acrylsäure und Vinylestern, Vinylethern, (Meth)Acrylsäureestern und/oder (Meth)Acrylsäureamiden; maleinierte Alkadienpolymerisate; durch Maleinierung und Teilveresterung oder Teilamidierung polymeranalog modifizierte Alkadienpolymerisate; Copolymerisate von Alkadienen mit α,β-olefinisch ungesättigten Carbonsäuren; carboxylgruppenhaltige Alkadien-Acrylnitril-Copolymerisate; partiell oder nahezu vollständig hydrolysierte Poly(vinylalkoholalkancarbonsäureester); oder partiell oder nahezu vollständig hydrolysierte Vinylalkoholalkancarbonsäureester-Alkylenoxid-Pfropfmischpolymerisate und gehen beispielsweise aus der EP-A-0 224 164, der EP-B-0 010 690 (US-A-4 272 611), der EP-A-0 183 552, der DE-A-30 12 841 (US-A-4 272 608), der DE-A-35 40 950 (EP-A-0 223 114), der DE-A-35 43 646 (EP-A-0 226 153), der DE-A-36 02 472 (EP-A-0 231 002) oder der DE-A-37 18 447 (EP-A-0 293 750) hervor.

Beispiele geeigneter mit organischen Lösungsmitteln entwickelbarer photopolymerisierbarer reliefbildender Aufzeichnungsschichten (B) oder oberster Einzelschichten (B) zur Verwendung in dem erfindungsgemäßen Aufzeichnungselement enthalten in organischen Lösungsmitteln lösliche oder quellbare Elastomere (b₁) wie Polyalkadiene, Alkadien-Acrylnitril-Copolymerisate, Vinylaromat-Alkadien-Copolymerisate, Vinylaromat-Alkadien-Blockmischpolymerisate, Butylkautschuke, Acrylatkautschuke, Polychloroprene, Fluorkautschuke, Silikonkautschuke, Polysulfidkautschuke oder Ethylen-Propylen-Alkadien-Copolymerisate.

Beispiele gut geeigneter, in organischen Lösungsmitteln löslicher oder quellbarer Elastomerer (b₁) sind Polyalkadiene,Vinylaromat-Alkadien-Copolymerisate, Vinylaromat-Alkadien-Blockmischpolymerisate, Alkadien-Acrylnitril-Copolymerisate oder Ethylen-Propylen-Alkadien-Copolymerisate.

Beispiele besonders gut geeigneter Elastomerer (b₁) dieser Art sind Naturkautschuk, die Homopolymerisate des Butadiens oder des Isoprens, Butadien-Isopren-Copolymerisate, Copolymerisate aus Styrol und Butadien und/oder Isopren mit statistischer Verteilung der einpolymerisierten Monomeren und einem Gehalt an einpolymerisiertem Styrol von vorzugsweise 10 bis 50 Gew.-%, die Vinylaromat-Alkadien-Blockmischpolymerisate, die Butadien-Acrylnitril-Copolymerisate mit einem Acrylnitrilgehalt von 15 bis 40 Gew.-% und die Ethylen-Propylen-Alkadien-Copolymerisate.

Beispiele für besonders gut geeignete Elastomere (b₁), welche in organischen Lösungsmitteln löslich oder quellbar sind, sind die Vinylaromat-Alkadien-Blockmischpolymerisate, welche mindestens einen elastomeren Alkadien-Polymerisatblock X und mindestens einen thermoplastischen Vinylaromaten-Polymerisat-Block Y enthalten, wobei die Blöcke X und Y im allgemeinen über Kohlenstoff-Kohlenstoff-Bindungen chemisch miteinander verknüpft sind. In einem gegebenen Blockmischpolymerisat kann die Verknüpfung von einem Block X mit einem Block Y auch durch ein statistisches oder ein alternierendes Copolymeres, welches konjugierte Alkadiene und Vinylaromaten einpolymerisiert enthält, erfolgen; oder aber die Verknüpfung der Blöcke X und Y erfolgt mittels eines Copolymerisats aus konjugierten Alkadienen und Vinylaromaten, in welchem die Konzentration einpolymerisierter konjugierter Alkadiene vom Block X zum Block Y hin ab- und die Konzentration einpolymerisierter Vinylaromaten zunimmt.

Darüber hinaus können die besonders gut geeigneten Blockmischpolymerisate über geeignete mehrbindige Atome oder Ionen sowie anorganische organische oder metallorganische Molekülreste zu noch größeren Blockmischpolymerisat-Verbänden verknüpft werden. Dabei ist unter Verknüpfung die Bildung kovalenter oder ionischer Bindungen zwischen zwei Molekülresten zu verstehen.

Außerdem können die olefinischen und aromatischen Bindungen oder auch nur die olefinischen Bindungen in den Alkadien-Polymerisatblöcken X partiell oder vollständig hydriert vorliegen. Zudem können die Blöcke X und Y weitere Monomere, bei welchen es sich nicht um konjugierte Alkadiene und Vinylaromaten handeln muß, einpolymerisiert enthalten, wie beispielsweise Acrylnitril, Acrylsäure, Maleinsäureanhydrid, (Meth)Acrylsäureamide oder (Meth)Acrylsäureester, wobei deren Anteil am Blockmischpolymerisat im allgemeinen 10 Gew.-% nicht übersteigen soll. Dabei können die Blöcke X auch Vinylaromaten einpolymerisiert enthalten, wobei deren Menge so gewählt wird, daß sie die elastomeren Eigenschaften der Blöcke X nicht beeinträchtigt. Ebenso können die Blöcke Y so viele konjugierte Alkadiene einpolymerisiert enthalten, daß ihre thermoplastische Verarbeitbarkeit nicht verlorengeht.

Enthält dabei ein gegebenes besonders gut geeignetes Blockmischpolymerisat mehrere elastomere Blöcke X und/oder mehrere thermoplastische Blöcke Y, dann müssen die Blöcke X bzw. Y nicht jeweils chemisch identisch oder angenähert gleich sein, sondern sie können sich jeweils deutlich voneinander unterscheiden, sofern sie stets die erforderlichen elastomeren bzw. thermoplastischen Eigenschaften aufweisen.

Im allgemeinen weisen Blöcke X eine Glastemperatur Tg von unterhalb 20°C, vorzugsweise unterhalb 0°C und insbesondere unterhalb -15°C auf. Diese Blöcke können im allgemeinen eine mittlere Molmasse von 10³ bis 2·10⁵ aufweisen. Im allgemeinen enthalten sie 30 bis 100, insbesondere 30 bis 95 Gew.-%, bezogen auf den jeweiligen Block X, an einpolymerisierten konjugierten Alkadienen.

Blöcke Y weisen im allgemeinen eine Glastemperatur Tg von mehr als 20°C auf. Sie haben im allgemeinen eine mittlere Molmasse von 1,5·10³ bis 2·10⁶, vorzugsweise 5·10³ bis 1,5·10⁶ und insbesondere 10⁴ bis 1,2·10⁶. Sie enthalten im allgemeinen 30 bis 100, insbesondere 40 bis 90 Gew.-%, bezogen auf den jeweiligen Block Y, an einpolymerisierten Vinylaromaten.

Beispiele für vorteilhafte konjugierte Alkadiene sind Butadien, Isopren, Pentan-1,3-dien, 2,3-Dimethylbutadien oder Hexan-2,4-dien, wobei Butadien und Isopren bevorzugt sind.

Beispiele für vorteilhafte Vinylaromaten sind Styrol, α-Methylstyrol, p-Methylstyrol, p-tert.-Butylstyrol oder 1-Vinylnaphthalin, wobei Styrol bevorzugt ist.

Als Beispiele für besonders vorteilhafte Blockmischpolymerisate seien die thermoplastisch elastomeren Dreiblockmischpolymerisate Y-X-X' angeführt, in denen Y einen thermoplastischen, nicht elastischen Styrolpolymerisatblock, X einen elastomeren Butadien- und/oder Isoprenpolymerisat-Block und X' einen von X verschiedenen elastomeren Polymerisat-Block aus einpolymerisiertem Butadien und/oder Isopren sowie gegebenenfalls einpolymerisiertem Styrol darstellt.

Als weitere Beispiele für besonders vorteilhafte Blockmischpolymerisate seien Blockmischpolymerisate des Aufbaus X-Y-X-Y, Y-X-X'-Y, Y-X-Y-X' oder X-X'-Y-X angeführt.

Weitere Beispiele besonders gut geeigneter in organischen Lösungsmitteln löslicher oder quellbarer Elastomerer (b₁) sind Ethylen-Propylen-Alkadien-Copolymerisate eines Ethylengehalts von 40 bis 80 Gew.-% und eines Doppelbindungsanteils von 2 bis 20 olefinischen Doppelbindungen je 1000 Kohlenstoffatome, welche vorteilhafterweise Butadien, Isopren, Penta-1,4-dien, Hexa-1,4-dien, Hepta-1,4-dien, Dicyclopentadien und/oder Ethylidennorbornen einpolymerisiert enthalten.

Sowohl die besonders gut geeigneten, mit organischen Lösungsmitteln entwickelbaren photopolymerisierbaren reliefbildenden Aufzeichnungsschichten (B) oder obersten Einzelschichten (B) als auch die besonders gut geeigneten, mit Wasser oder wäßrigen Lösungsmitteln entwickelbaren photopolymerisierbaren reliefbildenden Aufzeichnungsschichten (B) oder obersten Einzelschichten (B) zur Verwendung in dem erfindungsgemäßen Aufzeichnungselement bestehen vorteilhafterweise aus
(b₁) 20 bis 99 Gew.-% mindestens eines der vorstehend genannten, entweder in organischen Lösungsmitteln oder in Wasser oder wäßrigen Lösungsmitteln löslichen oder quellbaren Elastomeren als Bindemittel,
(b₂) 0,001 bis 10 Gew.-% mindestens eines Photopolymerisationsinitiators,
(b₃) 1 bis 60 Gew.-% mindestens eines olefinisch ungesättigten photopolymerisierbaren Monomeren, welches mit dem oder den jeweiligen Elastomeren (b₁) verträglich ist, und
(b₄) 0 bis 40 Gew.-% mindestens eines Hilfsstoffes.

Beispiele geeigneter Photopolymerisationsinitiatoren (b₂), olefinisch ungesättigter photopolymerisierbarer Monomerer (b₃) und Hilfsstoffe (b₄) für photopolymerisierbare reliefbildende Aufzeichnungsschichten (B) oder oberste Einzelschichten (B), welche entweder mit Wasser oder wäßrigen

Lösungsmitteln oder mit organischen Lösungsmitteln entwickelbar sind, sind üblich und bekannt und gehen beispielsweise aus dem eingangs zitierten Stand der Technik hervor.

Die photopolymerisierbaren reliefbildenden Aufzeichnungsschichten (B) sind 0,1 bis 7 und insbesondere 0,7 bis 6,5 mm dick.

Die erfindungsgemäß zu verwendende optisch transparente Deckschicht (C) ist 0,2 bis 25 µm dick und bedeckt die unter ihr liegende photopolymerisierbare reliefbildende Aufzeichnungsschicht (B) oder deren oberste Einzelschicht (B) vollständig und in gleichmäßiger Dicke. Sie ist lichtdurchlässig und stört somit nicht die bildmäßige Belichtung der photopolymerisierbaren reliefbildenden Aufzeichnungsschicht (B) mit aktinischem Licht. Sie ist in den Lösungsmitteln, mit denen die bildmäßig belichtete reliefbildende Aufzeichnungsschicht (B) oder deren oberste Einzelschicht (B) ausgewaschen wird, nicht löslich oder quellbar. Im allgemeinen ist sie sauerstoffundurchlässig, so daß sie eine Inhibierung der Photopolymerisation durch Luftsauerstoff in der photopolymerisierbaren reliefbildenden Aufzeichnungsschicht (B) verhindert. Sie ist nicht klebrig, so daß eine auf sie aufgelegte Bildmaske oder Negativvorlage leicht wieder vom erfindungsgemäßen Aufzeichnungselement abgelöst werden kann. Vorteilhafterweise haftet sie an der Oberfläche der photopolymerisierbaren oder bildmäßig belichteten reliefbildenden Aufzeichnungsschicht (B) fester als an der ihr gegebenenfalls aufliegenden Deckfolie (D).

Die optisch transparente Deckschicht (C) kann glatt sein, d.h. sie kann einen Oberflächenrauhwert Rₘₐₓ ≦ 0,1 µm aufweisen. Vorteilhafterweise ist sie mattiert, d.h. ihr Oberflächenrauhwert Rₘₐₓ liegt bei 0,1 bis 15, vorzugsweise 0,3 bis 10 und insbesondere 0,5 bis 7 µm. Durch die Mattierung wird die Zeit, in der die Bildmaske oder Negativvorlage mit dem erfindungsgemäßen Aufzeichnungselement in Kontakt gebracht werden kann, erheblich verkürzt.

Sofern die Dicke der optisch transparenten Deckschicht (C) geringer ist als ihr Oberflächenrauhwert Rₘₐₓ, ist die unter der optisch transparenten Deckschicht (C) liegende Oberfläche der photopolymerisierbaren reliefbildenden Aufzeichnungsschicht (B) gleichfalls mattiert, was oftmals von Vorteil ist

Die optisch transparente Deckschicht (C) enthält in der Hauptsache ein Polymeres, welches zur Bildung reißfester Filme in der Lage ist, oder sie besteht aus einem solchen Polymeren. Die Auswahl des Polymeren für den Aufbau der optisch transparenten Deckschicht (C) richtet sich in erster Linie nach den Löslichkeitseigenschaften des Polymeren einerseits und der hiermit zu bedeckenden photopolymerisierbaren reliefbildenden Aufzeichnungsschicht (B) oder deren obersten Einzelschicht (B) andererseits: Erfindungsgemäß sind die Löslichkeiten so aufeinander abzustimmen, daß die photopolymerisierbare reliefbildende Aufzeichnungsschicht (B) oder deren oberste Einzelschicht (B) bzw. das darin enthaltene polymere Bindemittel (b₁) einerseits und die optisch transparente Deckschicht (C) andererseits nicht in ein und demselben Lösungsmittel löslich oder quellbar sind.

Beispiele geeigneter erfindungsgemäß zu verwendender optisch transparenter Deckschichten (C) sowie ihre Löslichkeitsparameter sind allgemein bekannt und gehen beispielsweise aus dem eingangs zitierten Stand der Technik hervor.

Beispiele gut geeigneter erfindungsgemäß zu verwendender Polymerer für optisch transparente Deckschichten (C), welche in organischen Lösungsmitteln löslich oder quellbar sind, sind Polyamide, Copolyamide, Polyethylen, Polystyrol, Styrol-Acrylnitril-Copolymerisate, Polyvinylchlorid, Vinylchlorid-Vinylacetat-Copolymerisate, Polycarbonate, Silikonkautschuke, Polyester, Polyurethane, Poly(meth)acrylate, Cyclokautschuke eines hohen Cyclisierungsgrades, Ethylen-Propylen-Copolymerisate und Ethylen-Vinylacetat-Copolymerisate.

Beispiele für gut geeignete erfindungsgemäß zu verwendende Polymere für optisch transparente Deckschichten (C), welche in Wasser oder in wäßrigen Lösungsmitteln löslich oder quellbar sind, sind partiell oder nahezu vollständig hydrolysierte Poly(vinylalkoholalkancarbonsäureester), partiell oder nahezu vollständig hydrolysierte Vinylalkoholalkancarbonsäureester-Polyalkylenoxid-Pfropfmischpolymerisate, Gelatine, Celluloseester, Celluloseether, Polyvinylpyrrolidon, Vinylaromat-Alkandicarbonsäureanhydrid-Copolymerisate, Vinylether-Alkandicarbonsäureanhydrid-Copolymerisate, Poly(meth)acrylsäure, (Meth)Acrylsäure-(Meth)Acrylat-Copolymerisate und Polyalkylenoxide.

Außerdem kann die in Wasser oder in wäßrigen Lösungsmitteln lösliche oder quellbare optisch transparente Deckschicht (C) aus geeigneten niedermolekularen, in Wasser oder wäßrigen Lösungsmitteln löslichen Verbindungen aufgebaut sein. Beispiele geeigneter Verbindungen sind Saponine und Saccharide.

Beispiele besonders gut geeigneter erfindungsgemäß zu verwendender Polymere für die in Wasser oder in wäßrigen Lösungsmitteln lösliche oder quellbare optisch transparente Deckschicht (C) sind die partiell oder nahezu vollständig hydrolysierten Poly(vinylalkoholalkancarbonsäureester) und die partiell oder nahezu vollständig hydrolysierten Vinylalkoholalkancarbonsäureester-Polyalkylenoxid-Pfropfmischpolymerisate, von denen partiell oder nahezu vollständig hydrolysiertes Polyvinylacetat oder -propionat mit einem Hydrolysegrad von 60 bis 99 %, vorzugsweise 70 bis 98 Gew.-% und insbesondere 75 bis 95 % und einem zahlenmittleren Molekulargewicht M̅ₙ von 10⁴ bis 10⁵, insbesondere 1,5·10⁴ bis 5·10⁴ sowie das partiell oder nahezu vollständig hydrolysierte Ethylenoxid-Vinylacetat- und das Ethylenoxid-Vinylpropionat-Pfropfmischpolymerisat, welche durch Pfropfen von Vinylacetat oder -propionat auf Polyethylenoxid und anschließende Hydrolyse erhalten werden und einen Gehalt an einpolymerisiertem Ethylenoxid von 10 bis 30 Gew.-% aufweisen, ganz besonders gut geeignet sind.

Die erfindungsgemäßen Aufzeichnungselemente können demnach die folgenden erfindungsgemäßen Kombinationen umfassen:

### Kombination 1:

Eine mit organischen Lösungsmitteln entwickelbare photopolymerisierbare reliefbildende Aufzeichnungsschicht (B), welche eine Einzelschicht (B) darstellt, und eine in Wasser oder in wäßrigen Lösungsmitteln lösliche oder quellbare optisch transparente Deckschicht (C);

### Kombination 2:

Eine photopolymerisierbare reliefbildende Aufzeichnungsschicht (B), welche aus mindestens zwei Einzelschichten (B) besteht, wobei zumindest die direkt unter der Deckschicht (C) liegende, d.h. die oberste, Einzelschicht (B) mit organischen Lösungsmitteln entwickelbar ist, und eine in Wasser oder in wäßrigen Lösungsmitteln lösliche oder quellbare optisch transparente Deckschicht (C);

### Kombination 3:

Eine mit Wasser oder mit wäßrigen Lösungsmitteln entwickelbare photopolymerisierbare reliefbildende Aufzeichnungsschicht (B), welche eine Einzelschicht (B) darstellt, und eine in organischen Lösungsmitteln lösliche oder quellbare optisch transparente Deckschicht (C);

### Kombination 4:

Eine photopolymerisierbare reliefbildende Aufzeichnungsschicht (B), welche aus mindestens zwei Einzelschichten (B) besteht, wobei zumindest die direkt unter der Deckschicht (C) liegende, d.h. die oberste, Einzelschicht (B) mit Wasser oder wäßrigen Lösungsmitteln entwickelbar ist, und eine in organischen Lösungsmitteln lösliche oder quellbare optisch transparente Deckschicht (C).

Die erfindungsgemäßen Aufzeichnungselemente, welche die erfindungsgemäße Kombination 1 oder die erfindungsgemäße Kombination 4 umfassen, sind erfindungsgemäß ganz besonders vorteilhaft.

Ein weiterer wesentlicher Bestandteil des erfindungsgemäßen Aufzeichnungselements ist der dimensionsstabile Träger (A). Als dimensionsstabile Träger (A) können Platten, Folien oder konische oder zylindrische Röhren (sleeves) aus Metallen wie Stahl, Aluminium, Kupfer oder Nickel oder aus Kunststoffen wie Polyethylenterephthalat, Polybutylenterephthalat, Polyamid oder Polycarbonat verwendet werden. Außerdem kommen noch Gewebe und Vliese, z.B. Glasfasergewebe, oder Verbundmaterialien aus z.B. Glasfasern und Kunststoffen wie Polyethylenterephthalat in Betracht.

Der dimensionsstabile Träger (A) wiederum kann mit einer weichelastischen Unterschicht unterlegt sein. Außerdem kann sich zwischen dem dimensionsstabilen Träger (A) und der photopolymerisierbaren reliefbildenden Aufzeichnungsschicht (B) eine Haftschicht befinden, durch welche eine haftfeste Verbindung zwischen (A) und (B) erreicht wird. Es ist indes auch möglich und in manchen Fällen zweckmäßig, die photopolymerisierbare reliefbildende Aufzeichnungsschicht (B) mit dem dimensionsstabilen Träger (A) leicht ablösbar zu verbinden.

Als Haftschichten werden mit Vorteil übliche und bekannte, etwa 0,5 bis 40 µm starke Haftlackschichten verwendet.

Werden als dimensionsstabile Träger (A) stark reflektierende Platten oder Folien verwendet, dann können sie geeignete Lichthofschutzmittel wie Ruß oder Mangandioxid enthalten. Die Lichthofschutzmittel können aber auch als separate Schicht auf den dimensionsstabilen Träger (A) aufgetragen werden oder in der Haftlackschicht oder in der photopolymerisierbaren reliefbildenden Aufzeichnungsschicht (B) enthalten sein.

Des weiteren kann das erfindungsgemäße Aufzeichnungselement eine optisch transparente oder nicht transparente Deckfolie (D) enthalten, welche sich von der optisch transparenten Deckschicht (C) leicht ablösen läßt.

Die Deckfolien (D) sind üblicherweise 10 bis 250, insbesondere 20 bis 150 µm dick. Sie bestehen im wesentlichen aus Kunststoffen, textilen Stoffen, Papieren oder Metallen. Diejenige Oberfläche der Deckfolie (D), welche der optisch transparenten Deckschicht (C) unmittelbar aufliegt, ist glatt, d.h. sie weist einen Oberflächenrauhwert Rₘₐₓ ≦ 0,1 µm auf, oder sie ist mattiert, d.h. sie hat einen Oberflächenrauhwert Rₘₐₓ zwischen 0,1 und 15, vorzugsweise 0,3 bis 10 und insbesondere 0,5 bis 7 µm. Sofern die Deckfolie (D) mattiert ist, prägt sich ihr Rauheitsmuster in die optisch transparente Deckschicht (C) und gegebenenfalls auch noch in die Oberfläche der photopolymerisierbaren reliefbildenden Aufzeichnungsschicht (B) ein. Diese glatte oder mattierte Oberfläche der Deckfolie (D) kann außerdem antihaftend ausgerüstet sein, d.h. sie kann beispielsweise eine 0,1 bis 0,5 µm starke Antihaftschicht aus üblichen und bekannten Silikonen oder aus anderen Kunststoffen wie Polyethylen oder Polypropylen aufweisen. Deckschichten (D) aus textilen Stoffen oder aus Papieren können zudem mit Kunststoffen wie Harnstoff-Formaldehyd-Harze oder Polyolefine imprägniert sein. Die Deckschichten (D) aus Kunststoffen können überdies biaxial gereckt sein. Hierbei ist es oftmals von Vorteil, vor der biaxialen Reckung eine 0,1 bis 0,5 µm starke Schicht aus beispielsweise einem Vinylidenchloridcopolymerisat auf derjenigen Seite von (D) aufzutragen, welche später der optisch transparenten Deckschicht (C) direkt aufliegt.

Die Herstellung des erfindungsgemäßen Aufzeichnungselements weist keine technischen Besonderheiten auf, sondern erfolgt nach den üblichen und bekannten Methoden der Herstellung photopolymerisierbarer reliefbildender Schichten und Deckschichten sowie nach den üblichen und bekannten Methoden der Herstellung von Folien aus Kunststoffen, textilen Stoffen, Papieren oder Metallen.

So werden die photopolymerisierbaren reliefbildenden Aufzeichnungsschichten (B) oder die Einzelschichten (B) üblicherweise durch das Mischen ihrer vorstehend beschriebenen Bestandteile (b₁), (b₂), (b₃) und (b₄) mittels der üblichen Knet-, Misch- und Lösungstechniken und durch Formen der hierbei resultierenden photopolymerisierbaren Gemische (B) zu photopolymerisierbaren reliefbildenden Aufzeichnungsschichten (B) oder Einzelschichten (B) mittels Gießen aus Lösung, Heißpressen, Kalandrieren oder Extrudieren hergestellt. Hierbei kann die Herstellung der photopolymerisierbaren reliefbildenden Aufzeichnungsschicht (B) separat erfolgen oder sie kann in das Verfahren zur Herstellung des erfindungsgemäßen Aufzeichnungselements integriert sein.

Die optisch transparente Deckschicht (C) wird üblicherweise nach Methoden hergestellt, wie sie auch für die Herstellung der photopolymerisierbaren reliefbildenden Aufzeichnungsschicht (B) in Betracht kommen, wobei die Herstellung der optisch transparenten Deckschicht (C) üblicherweise in das Verfahren zur Herstellung des erfindungsgemäßen Aufzeichnungselements integriert ist.

Die Bestandteile der gegebenenfalls mitverwendeten Deckfolien (D) werden, sofern sie aus Kunststoffen bestehen, mittels der üblichen Knet-, Misch- und Lösungstechniken vermengt und durch Gießen aus Lösung, Heißpressen, Kalandrieren oder Extrudieren und Blasformen zu den entsprechenden Folien geformt. Auch diese Arbeitsgänge können in das Verfahren zur Herstellung des erfindungsgemäßen Aufzeichnungselements integriert sein; üblicherweise werden indes die Deckfolien (D) separat hergestellt, auf Rollen aufgewickelt und in dieser Form für die Herstellung des erfindungsgemäßen Aufzeichnungselements verwendet.

Auch die Herstellung des erfindungsgemäßen Aufzeichnungselements aus seinen vorstehend genannten Bestandteilen weist keine technischen Besonderheiten auf, sondern erfolgt in üblicher Weise durch Verbinden der photopolymerisierbaren reliefbildenden Aufzeichnungsschicht (B) mit der optisch transparenten Deckschicht (C) und gegebenenfalls der Deckfolie (D), wobei dies auch auf dem dimensionsstabilen Träger (A) gegebenenfalls unter Mitverwendung einer Haftlackschicht und einer weichelastischen Unterschicht erfolgen kann. Hierbei ist es grundsätzlich möglich, die photopolymerisierbare reliefbildende Aufzeichnungsschcht (B) zuerst mit dem dimensionsstabilen Träger (A) zu verbinden und anschließend ihre unbedeckte Seite mit der optisch transparenten Deckschicht (C) und gegebenenfalls der Deckfolie (D) zu bedecken, oder aber die photopolymerisierbare reliefbildende Aufzeichnungsschicht (B) wird zunächst auf die mit der optisch transparenten Deckschicht (C) überzogene Deckfolie (D) aufgetragen und dann erst mit dem dimensionsstabilen Träger (D) verbunden. Selbstverständlich können diese Arbeitsgänge in üblichen und bekannten, kontinuierlich oder diskontinuierlich arbeitenden Anlagen hintereinander oder gleichzeitig ausgeführt werden.

Ferner kann die photopolymerisierbare reliefbildende Aufzeichnungsschicht (B) aus mehreren Einzelschichten (B) hergestellt werden. Diese Einzelschichten (B) können dabei von gleicher, in etwa gleicher oder von unterschiedlicher stofflicher Zusammensetzung sein. Erfindungsgemäß werden Einzelschichten (B) unterschiedlicher stofflicher Zusammensetzung bevorzugt. Ein geeignetes Verfahren zur Herstellung der aus photopolymerisierbaren Einzelschichten (B) aufgebauten photopolymerisierbaren reliefbildenden Aufzeichnungsschicht (B) geht beispielsweise aus der EP-A-0 084 851 oder der DE-A-29 42 183 (US-A-4 320 188) hervor oder wird in der deutschen Patentanmeldung P 38 33 650.2 beschrieben.

Das erfindungsgemäße Aufzeichnungselement weist bereits bei seiner Herstellung besondere unerwartete Vorteile auf, welche sich aus der neuartigen Kombination einer photopolymerisierbaren reliefbildenden Aufzeichnungsschicht (B) und einer optisch transparenten Deckschicht (C) unterschiedlicher Löslichkeitseigenschaften ergeben: So kann seine optisch transparente Deckschicht (C) in vorteilhafter Weise durch Gießen aus Lösung auf seine bereits vorhandene photopolymerisierbare reliefbildende Aufzeichnungsschicht (B) aufgebracht werden, ohne daß hierbei in irgendeiner Weise die Oberfläche der photopolymerisierbaren reliefbildenden Aufzeichnungsschicht (B) angegriffen wird. Außerdem kann das erfindungsgemäße Aufzeichnungselement in den vom Stand der Technik her bekannten Anlagen und Apparaturen hergestellt werden, so daß Umbauten bereits vorhandener Anlagen und Apparaturen oder gar Neuinvestitionen in neue, speziell zu entwickelnde Anlagen und Apparaturen entfallen.

Nach seiner Herstellung erweist sich das erfindungsgemäße Aufzeichnungselement als dimensionsstabil, wobei es nicht zum kalten Fließen neigt. Von ganz besonderem Vorteil ist, daß die in seiner photopolymerisierbaren reliefbildenden Aufzeichnungsschicht (B) enthaltenen niedermolekularen Verbindungen wie die photopolymerisierbaren olefinisch ungesättigten Monomere (b₃), die Photopolymerisationsinitiatoren (b₂) und die Hilfsstoffe (b₄) nicht mehr länger in störendem Ausmaß in die optisch transparente Deckschicht (C) diffundieren und von da aus in die Atmosphäre entweichen. Dadurch ist das erfindungsgemäße Aufzeichnungselement völlig oder weitgehend geruchsfrei, so daß bei seiner Handhabung keine besonderen sicherheitstechnischen Maßnahmen wie eine starke Luftabsaugung mehr notwendig sind. Des weiteren neigt die optisch transparente Deckschicht (C) bei längerer Lagerung des erfindungsgemäßen Aufzeichnungselements nicht mehr zur Bildung von Schlieren oder Trübungen, sondern bleibt optisch transparent und klar, so daß die Belichtungseigenschaften des erfindungsgemäßen Aufzeichnungselements nicht in nachteiliger Weise geändert werden. Außerdem haftet die optisch transparente Deckschicht (C) fest an der Oberfläche der photopolymerisierbaren reliefbildenden Aufzeichnungsschicht (B) und neigt auch nicht beim Biegen des erfindungsgemäßen Aufzeichnungselements zum Aufwerfen oder zur Bildung von Rissen. Selbst beim Zuschneiden des lichtempfindlichen Aufzeichnungselements auf eine Größe, welche bei flexographischen Reliefdruckplatten üblich ist, wird keine Ablösung der optisch transparenten Deckschicht (C) von der Oberfläche der photopolymerisierbaren reliefbildenden Aufzeichnungsschicht (B) beobachtet.

Darüber hinaus neigt das erfindungsgemäße Aufzeichnungselement deutlich weniger zum Verschmutzen durch Ablagerung von Staubpartikel aus der Luft, so daß es auch ohne Deckfolie (D) im reprographischen Betrieb problemlos gehandhabt und auch längere Zeit bis zu seiner endgültigen Weiterverarbeitung zu der flexographischen Reliefdruckplatte gelagert werden kann, was dem Reprographen mehr Spielraum bei der zeitlichen Planung der Arbeitsgänge in seinem Betrieb gibt.

Die besonderen Vorteile des erfindungsgemäßen Aufzeichnungselements treten auch bei seiner Verwendung für die Herstellung von flexographischen Reliefdruckplatten in überzeugender Weise zu Tage.

Bekanntermaßen umfaßt die Herstellung einer flexographischen Reliefdruckplatte aus einem lichtempfindlichen Aufzeichnungselement die folgenden üblichen Arbeitsgänge:
(i) gegebenenfalls Vorbehandeln des lichtempfindlichen Aufzeichnungselements,
(ii) Ablösen der gegebenenfalls vorhandenen Deckfolie (D) von der optisch transparenten Deckschicht (C),
(iii) Auflegen einer Bildmaske oder Negativvorlage auf die optisch transparente Deckschicht (C),
(iv) bildmäßiges Belichten der photopolymerisierbaren reliefbildenden Aufzeichnungsschicht (B) mit aktinischem Licht einer Wellenlänge λ zwischen 250 und 450, insbesondere 350 und 450 nm,
(v) Auswaschen (Entwickeln) der unbelichteten Bereiche der bildmäßig belichteten reliefbildenden Aufzeichnungsschicht (B) mittels geeigneter Lösungsmittel,
(vi) Trocknen sowie
(vii) gegebenenfalls Nachbehandeln der in dieser Weise erhaltenen flexographischen Reliefdruckplatte bzw. ihrer photopolymerisierten Reliefschicht.

Ein Beispiel für die Vorbehandlung ist die vollflächige Belichtung der photopolymerisierbaren reliefbildenden Aufzeichnungsschicht (B) von ihrer Rück- und/oder Vorderseite her mit aktinischem Licht.

Beispiele für geeignete Nachbehandlungsmethoden sind die Nachbehandlung mit bromhaltigen Lösungen, das vollflächige Nachbelichten mit aktinischem Licht einer Wellenlänge λ zwischen 250 und 450 nm sowie das Nachbelichten mit Licht einer Wellenlänge λ kleiner als 250 nm.

Beispiele geeigneter Lichtquellen für aktinisches Licht sind handelsübliche UV-Fluoreszenz-Röhren, Quecksilbermittel-, -hoch- und -niederdruckstrahler, superaktinische Leuchtstoffröhren, Xenon-Impulslampen, mit Metalliodiden dotierte Lampen, Kohlebogenlampen oder Sterilisationslampen.

Beispiele geeigneter organischer Lösungsmittel für die Entwicklung sind aliphatische oder aromatische Kohlenwasserstoffe wie n-Hexan, n-Heptan, Octan, Cyclooctan, Dekalin, Hexylcyclopentan, Hexylcyclohexan, Petrolether, Ligroin, Testbenzine, entaromatisierte Testbenzine, synthetische Isoparaffine, n-Paraffine, hydrierte Mineralöle, Petroleumfraktionen, hydrierte Erdölfraktionen, Limonen und andere Terpene, Xylol, Ethylbenzol, die diethylsubstituierten Benzole, n-Butylbenzol, n-Pentylbenzol, n-Hexylbenzol und Isopropylbenzol sowie Gemische aus diesen Lösungsmitteln; Ketone wie Aceton, Methylethylketon, Ethylbutylketon und Dibutylketon; Ether wie Diethylether, Tetrahydrofuran, Dioxan und Di-n-butylether; Ester wie Essigsäureethylester, Acetessigsäureethylester, Hexyl-, Heptyl-, Octyl-, Nonyl-, Decyl-, Undecyl-, Dodecyl-, Lauryl-, Palmityl- und Oleylacetat und Sebacinsäure- und Adipinsäuredioctylester; halogenierte aliphatische Kohlenwasserstoffe wie Methylenchlorid, Chloroform, die Trichlorethane, Trichlorethylen, Tetrachlorethylen, Dichlortetrafluorethan und Trichlortrifluorethan; Gemische, die zwei oder mehr dieser Lösungsmittel enthalten; und Gemische, welche eines oder mehrerer dieser Lösungsmittel sowie zusätzlich noch Alkohole wie Methanol, Ethanol, Isopropanol, n-Butanol, n-Pentanol und/oder n-Hexanol enthalten; sowie Lösungsmittel und Gemische der genannten Art, welche zusätzlich noch feste, flüssige oder gasförmige organische und anorganische Verbindungen, wie etwa Tenside, in untergeordneten Mengen enthalten. Von diesen organischen Lösungsmitteln sind diejenigen besonders vorteilhaft, welche nicht brennbar oder schwer brennbar und/oder hoch siedend sind, wobei die Bezeichnung "nicht brennbar" darauf hinweist, daß die betreffenden Lösungsmittel die Verbrennung unter dem Sauerstoffpartialdruck der Luft nicht unterhalten, die Bezeichnung "schwer brennbar" darauf verweist, daß die betreffenden Lösungsmittel einen Flammpunkt nach DIN 51 755 oder DIN 51 758 von mehr als 45°C haben und die Bezeichnung "hoch siedend" einen Siedepunkt oder Siedebereich des betreffenden Lösungsmittels oberhalb 120, vorzugsweise 140 und insbesondere 160°C anzeigt.

Beispiele geeigneter wäßriger Lösungsmittel sind neben Wasser wäßrige Lösungen von Lithium-, Natrium- oder Kaliumhydroxid oder von Lithium-, Natrium- oder Kaliumcarbonat oder -hydrogencarbonat oder von Ammoniak, welche zusätzlich noch feste, flüssige oder gasförmige organische und anorganische Verbindungen, wie etwa sonstige Salze, Komplexbildner oder Tenside, in untergeordneten Mengen enthalten können.

Das erfindungsgemäße Aufzeichnungselement kann selbstverständlich für das vorstehend im Detail beschriebene bekannte Verfahren zur Herstellung einer flexographischen Reliefdruckplatte verwendet werden. Indes ergibt sich hierbei aufgrund der unterschiedlichen Löslichkeitseigenschaften seiner optisch transparenten Deckschicht (C) einerseits und der nicht belichteten und daher nicht photopolymerisierten Bereiche seiner bildmäßig belichteten reliefbildenden Aufzeichnungsschicht (B) oder seiner obersten Einzelschicht (B) andererseits u.U. die Notwendigkeit, die Entwicklung in zwei Arbeitsgängen durchzuführen, wobei in dem einen Arbeitsgang ein organisches Lösungsmittel und in dem anderen Arbeitsgang Wasser oder ein wäßriges Lösungsmittel verwendet wird.

Erfindungsgemäß ist es indes von ganz besonderem Vorteil, das Entwickeln des bildmäßig belichteten erfindungsgemäßen Aufzeichnungselements mit Hilfe des erfindungsgemäßen Verfahrens zur Herstellung einer flexographischen Reliefdruckplatte durchzuführen.

Bei dem erfindungsgemäßen Verfahren erfolgt - ungeachtet der unterschiedlichen Löslichkeitseigenschaften der optisch transparenten Deckschicht (C) und der nicht belichteten und daher nicht photopolymerisierten Bereiche der bildmäßig belichteten reliefbildenden Aufzeichnungsschicht (B) - die Entwicklung in einem Arbeitsgang.

Erfindungsgemäß wird dies durch die Verwendung einer Emulsion vom Typ "Wasser-in-Öl" oder vom Typ "Öl-in-Wasser" als dem alleinigen Entwickler bewerkstelligt.

Die erfindungsgemäß zu verwendende Wasser-in-Öl-Emulsion besteht aus einer fein dispergierten wäßrigen Phase und einer kontinuierlichen nicht brennbaren oder schwer brennbaren und/oder hoch siedenden organischen Phase im Volumenverhältnis von 90:10 bis 10:90, wobei Volumenverhältnisse von 60:40 bis 40:60 von besonderem Vorteil sind.

Als organische Phase oder Bestandteil der organischen Phase kommen all die vorstehend genannten organischen Lösungsmittel in Betracht, welche mit Wasser nicht mischbar und außerdem schwer oder nicht brennbar und/oder hochsiedend sind. Von diesen sind Tetrachlorethylen und die entaromatisierten Testbenzine besonders und die entaromatisierten Testbenzine ganz besonders vorteilhaft.

Darüber hinaus kann die erfindungsgemäß zu verwendende Wasser-in-Öl-Emulsion, , bezogen auf ihre Gesamtmenge 0,1 bis 20 Vol.% mindestens eines der vorstehend genannten Alkohole und/oder 0,001 bis 10 Vol.% mindestens einer oberflächenaktiven Verbindung bzw. eines Tensids oder Emulgators enthalten.

Beispiele geeigneter Emulgatoren sind solche, welche Wasser-in-Öl-Emulsionen stabilisieren. Beispiele gut geeigneter Emulgatoren sind Kondensationsprodukte von Fettaminen mit Ethylenoxid, Kondensationsprodukte von Alkoholen mit langkettigen Fettsäuren und Kondensationsprodukte von Aminoalkoholen mit langkettigen Fettsäuren.

Beispiele besonders gut geeigneter Emulgatoren sind Addukte aus Glycerin, Epichlorhydrin, Oleylalkohol und Ethylenoxid, Sorbitanmonostearat und Addukte aus einem Aminoalkohol und Oleinsäure.

Die erfindungsgemäß zu verwendende Öl-in-Wasser-Emulsion besteht aus einer fein dispergierten organischen Phase und einer kontinuierlichen wäßrigen Phase im Volumenverhältnis von 90:10 bis 10:90, wobei Volumenverhältnisse von 60:40 bis 40:60 von besonderem Vorteil sind.

Als organische Phase oder Bestandteil der organischen Phase kommen all die vorstehend genannten organischen Lösungsmittel in Betracht, welche nicht notwendigerweise schwer oder nicht brennbar und/oder hochsiedend sein müsen. Von Vorteil sind allerdings die schwer oder nicht brennbaren und/oder hochsiedenden Lösungsmittel wie Tetrachlorethylen oder die entaromatisierten Testbenzine.

Auch die erfindungsgemäß zu verwendende Öl-in-Wasser-Emulsion kann die vorstehend genannten Alkohole und/oder oberflächenaktiven Verbindungen wie Tenside oder Emulgatoren in den vorstehend angegebenen Mengen enthalten, wobei hier bevorzugt Emulgatoren wie Natriumdodecylhydrogensulfat, die Öl-in-Wasser-Emulsionen stabilisieren, zur Anwendung kommen.

Die für das erfindungsgemäße Verfahren jeweils zu verwendende, besonders vorteilhafte Emulsion kann in einfacher Weise ausgewählt werden: Die Auswahl wird aufgrund der Löslichkeitseigenschaften der in einem gegebenen erfindungsgemäßen Aufzeichnungselement vorhandenen stärksten zu entwickelnden Schicht getroffen. So wird das bildmäßig belichtete erfindungsgemäße Aufzeichnungselement, welches die erfindungsgemäße Kombination 1 oder 2 umfaßt, in erfindungsgemäß besonders bevorzugter Verfahrensweise mit der Wasser-in-Öl-Emulsion entwickelt, wogegen das bildmäßig belichtete erfindungsgemäße Aufzeichnungselement, welches die erfindungsgemäße Kombination 3 oder 4 umfaßt, in erfindungsgemäß besonders bevorzugter Verfahrensweise mit der Öl-in-Wasser-Emulsion entwickelt wird.

Vorteilhafterweise wird die erfindungsgemäß zu verwendende Wasser-in-Öl-oder Öl-in-Wasser-Emulsion bei dem erfindungsgemäßen verfahren unmittelbar vor der Entwicklung des bildmäßig belichteten erfindungsgemäßen Aufzeichnungselements in den üblicherweise für die Entwicklung verwendeten Bürsten-, Rund- oder Reibewaschern durch Umpumpen der Bestandteile der Emulsion hergestellt.

Das erfindungsgemäße verfahren sowie die mit Hilfe des erfindungsgemäßen Verfahrens aus dem erfindungsgemäßen Aufzeichnungselement hergestellten flexographischen Reliefdruckplatten weisen besondere unerwartete vorteile auf:

Bei dem erfindungsgemäßen verfahren entfallen aufgrund der Verwendung der Öl-in-Wasser- oder der Wasser-in-Öl-Emulsion zahlreiche sicherheitstechnische, ökologische und toxikologische Probleme, welche bislang stets mit der Verwendung üblicher und bekannter organischer Entwicklerlösungsmittel verbunden waren. Darüber hinaus kann die erfindungsgemäß zu verwendende Öl-in-Wasser- oder Wasser-in-Öl-Emulsion trotz ihres hohen Gehaltes an hochsiedender organischer Phase in einfacher Weise durch Destillation unter Normaldruck aufgearbeitet und hiernach wiederverwendet werden.

Ein weiterer besonderer überraschender Vorteil des erfindungsgemäßen Verfahrens ist, daß seine Anwendung nicht nur auf das erfindungsgemäße Aufzeichnungselement beschränkt ist, sondern daß es auch ganz vorzüglich für die Herstellung einer flexographischen Reliefdruckplatte aus dem lichtempfindlichen Aufzeichnungselement geeignet ist, welches in der deutschen Patentanmeldung P 38 33 650.2 beschrieben wird.

Dieses lichtempfindliche Aufzeichnungselement enthält einen dimensionsstabilen Träger (A), eine mindestens zwei Einzelschichten (B) mit unterschiedlichen Löslichkeitseigenschaften umfassende photopolymerisierbare Aufzeichnungsschicht (B) und eine an der Oberfläche von (B) fest anhaftende optisch transparente Deckschicht (C) mit den gleichen Löslichkeitseigenschaften wie die unmittelbar darunter liegende, d.h. die oberste, Einzelschicht (B).

Dieses lichtempfindliche Aufzeichnungselement kann nach seiner bildmäßigen Belichtung mit aktinischem Licht mit Hilfe der vorstehend beschriebenen erfindungsgemäß zu verwendenden Wasser-in-Öl- oder Öl-in-Wasser-Emulsion in einem Arbeitsgang entwickelt werden, wobei zugleich die unbelichteten Bereiche von mindestens zwei Einzelschichten (B) unterschiedlicher Löslichkeitseigenschaften und die optisch transparente Deckschicht (C) ausgewaschen werden.

Auch bei dieser Variante des erfindungsgemäßen Verfahrens richtet sich die Auswahl der jeweils zu verwendenden besonders vorteilhaften Emulsion nach den Löslichkeitseigenschaften der in dem lichtempfindlichen Aufzeichnungselement vorhandenen stärksten zu entwickelnden Schicht.

Die druckende Oberfläche der photopolymerisierten Reliefschichten der in erfindungsgemäßer Verfahrensweise hergestellten flexographischen Reliefdruckplatten ist von vorzüglicher Qualität. Insbesondere weist sie nicht mehr länger Oberflächenstrukturen in Form von Runzeln, Würmchen oder Tropfenspuren, d.h. die sogenannte Orangenhaut, und Polymerreste in der Form sogenannter Tropfnasen auf. Außerdem geben die photopolymerisierten Reliefschichten der flexographischen Reliefdruckplatten die Motive der Bildmaske oder Negativvorlage völlig detailgetreu wieder. Die betreffenden flexographischen Reliefdruckplatten lassen sich daher vorzüglich für den Flexoendlosdruck verwenden, wobei sie exzellente Druckerzeugnisse in besonders hoher Auflage liefern.

### Beispiele und Vergleichsversuche

### Beispiel 1

Herstellung eines erfindungsgemäßen Aufzeichnungselements mit wasserlöslicher optisch transparenter Deckschicht (C) und seine Weiterverarbeitung zu einer flexographischen Reliefdruckplatte

Für die Herstellung der wasserlöslichen optisch transparenten Deckschicht (C) wurden 5 kg eines partiell hydrolysierten Vinylacetat-Ethylenoxid-Pfropfmischpolymerisats (Mowiol® 04-M1 der Fa. Hoechst) in 100 kg Leitungswasser bei 80°C während 2 Stunden gelöst. Die resultierende Lösung wurde durch ein Papierfilter filtriert und im Anschluß daran auf eine mattierte Polyethylenterephthalat-Folie (Deckfolie D) der Stärke 125 µm ausgegossen, so daß nach 15 minütiger Trocknung bei 70°C ein gleichmäßiger 4 µm starker Film aus dem Mowiol® 04-M1 resultierte.

Zur Herstellung der mit organischen Lösungsmitteln entwickelbaren photopolymerisierbaren reliefbildenden Aufzeichnungsschicht (B) wurde in bekannter Weise eine Mischung aus
- 43,5 kg eines Styrol-Isopren-(Styrol-Butadien)-Dreiblockmischpolymerisates (in organischen Lösungsmitteln lösliches oder quellbares Elastomeres b₁),
- 0,6 kg Benzildimethylacetal (Photopolymerisationsinitiator b₂),
- 2,5 kg Hexan-1,6-diol-diacrylat (photopolymerisierbares olefinisch ungesättigtes Monomeres b₃),
- 2,5 kg Paraffinöl (Hilfsstoff b₄),
- 0,6 kg 2,6-Di-tert.-butyl-p-kresol (Hilfsstoff b₄) und
- 0,0032 kg des Farbstoffs Solvent Black (C.I. 26 150) (Hilfsstoff b₄)

extrudiert. Hierbei wurde der Stoffdurchsatz durch den Extruder so geregelt, daß eine 2800 µm dicke photopolymerisierbare reliefbildende Aufzeichnungsschicht (B) erhalten wurde.

Zur Herstellung des photopolymerisierbaren reliefbildenden Aufzeichnungselements wurde diese photopolymerisierbare reliefbildende Aufzeichnungsschicht (B) in den Spalt eines Zweiwalzenkalanders eingeführt, über dessen obere Walze der Verbund aus der optisch transparenten Deckschicht (C) und der Deckfolie (D) und über dessen untere Walze eine mit einer dünnen Haftlackschicht versehene, 150 µm starke Polyethylenterephthalatfolie (dimensionsstabiler Träger A) eingeführt wurden. Die Temperatur der Kalandrierwalzen lag bei 80°C. Im Spalt des Kalanders wurden die Bestandteile (A), (B), (C) und (D) haftfest miteinander verbunden, wonach das hierbei resultierende erfindungsgemäße Aufzeichnungselement auf einem Vakuumsaugband abgekühlt und formatgerecht zugeschnitten wurde. Beim Zuschneiden wurde keine Ablösung der optisch transparenten Deckschicht (C) von der photopolymerisierbaren reliefbildenden Aufzeichnungsschicht (B) beobachtet.

Nach zweitägiger Lagerung wurden die zugeschnittenen erfindungsgemäßen Aufzeichnungselemente während 30 Sekunden von ihrer Rückseite, d.h. durch den dimensionsstabile Träger (A) hindurch, mit einem 100-Watt-Belichter mit aktinischem Licht vorbelichtet.

Im Anschluß daran wurde die Deckfolie (D) von der optisch transparenten Deckschicht (C) mühelos abgezogen, ohne daß es hierbei zu einer merklichen elektrostatischen Aufladung der zugeschnittenen erfindungsgemäßen Aufzeichnungselemente kam. Die optisch transparente Deckschicht (C) verblieb vollständig und unbeschädigt auf der photopolymerisierbaren reliefbildenden Aufzeichnungsschicht (B). Beim Biegen der zugeschnittenen erfindungsgemäßen Aufzeichnungselemente blieb deren optisch transparente Deckschicht (C) unverletzt; es wurde nur eine sehr feine Strukturierung beobachtet. Die Oberfläche der zugeschnittenen erfindungsgemäßen Aufzeichnungselemente war gleichmäßig mattiert und völlig klebfrei. Die deckfolienfreien zugeschnittenen erfindungsgemäßen Aufzeichnungselemente konnten vor ihrer Weiterverarbeitung auch längere Zeit an der Luft gelagert werden, ohne daß es hierbei zu einer nachteiligen Änderung ihrer anwendungstechnischen Eigenschaften kam. Insbesondere traten keine Geruchsbelästigung, keine Ablagerung von Schmutzteilchen wie Staubpartikel und keine Trübung der optisch transparenten Deckschicht (C) auf.

Zur Herstellung flexographischer Reliefdruckplatten wurden die deckfolienfreien zugeschnittenen erfindungsgemäßen Aufzeichnungselemente in Vakuumrahmen eingelegt und durch Anlegen von Vakuum in innigen Kontakt mit den auf die optisch transparenten Deckschichten (C) aufgelegten Standardnegativen gebracht. Hierbei war der Kontakt der Standardnegative mit den optisch transparenten Deckschichten (C) ausgezeichnet. Hiernach wurden die erfindungsgemäßen Aufzeichnungselemente mit Hilfe eines Röhrenflachbelichters während 12 Minuten bildmäßig mit aktinischem Licht belichtet. Nach der bildmäßigen Belichtung konnten die Standardnegative mühelos von den optisch transparenten Deckschichten (C) entfernt werden.

Für die Entwicklung der bildmäßig belichteten zugeschnittenen erfindungsgemäßen Aufzeichnungselemente wurden in einem Trommelbürstenwascher von 60 l Fassungsvermögen 30 l eines entaromatisierten Testbenzins (Siedebereich 186 bis 218°C; Flammpunkt nach DIN 51 755: 61°C; Aromatengehalt: <1 %; Gehalt an naphthenischen Kohlenwasserstoffen: 35 %; Paraffingehalt: >64 %; EXXSOL® D 60 von Esso) vorgelegt. Anschließend wurden 30 l Leitungswasser hinzugegeben. Hieraus wurde die für die Entwicklung verwendete Wasser-in-Öl-Emulsion durch einminütiges Umpumpen erzeugt. Der Flammpunkt nach DIN 51 755 der Emulsion lag bei 63°C, so daß der Trommelbürstenwascher ohne Explosionsschutz betrieben werden konnte. Außerdem war die Emulsion so gut wie geruchsfrei.

Die bildmäßig belichteten zugeschnittenen erfindungsgemäßen Aufzeichnungselemente wurden in den Trommelbürstenwascher eingespannt und unmittelbar nach dem Umpumpen der Emulsion während 10 Minuten ausgewaschen. Die Temperatur der Emulsion lag bei 20°C. Die Emulsion wurde solange zum Entwickeln verwendet, bis ihr Feststoffgehalt bei 5 % lag.

Nach dem Entwickeln wurden die resultierenden flexographischen Reliefdruckplatten sorgfältig mit reinem entaromatisiertem Testbenzin abgespült, bis sämtliche Wassertröpfchen von der Oberfläche ihrer photopolymerisierten Reliefschichten verschwunden waren. Hiernach wurden sie in einen Umlufttrockenschrank bei 70°C während 2 Stunden getrocknet. Nach einer Ruhezeit von 12 Stunden wurden die flexographischen Reliefdruckplatten bzw. ihre photopolymerisierten Reliefschichten mit einer wäßrigen Bromlösung nachbehandelt und im Anschluß daran während 10 Minuten mit aktinischem Licht nachbelichtet.

Die Relieftiefe der in dieser Weise erhaltenen flexographischen Reliefdruckplatten war 1200 µm. Die druckende Oberfläche ihrer photopolymerisierten Reliefschichten war gleichmäßig matt, klebfrei und frei von Polymerresten in der Form von Tropfnasen und wies auch keine Orangenhaut auf. Außerdem waren die flexographischen Reliefdruckplatten völlig geruchlos. Darüber hinaus gaben ihre photopolymerisierten Reliefschichten die Motive der Negativvorlage völlig detailgetreu wieder und wiesen auch keine Beschädigungen in der Form von Ausbrüchen oder Unterwaschungen auf.

Die flexographischen Reliedruckplatten wurden auf Druckzylinder aufgespannt und in einem üblichen und bekannten Flexodruckwerk unter Verwendung üblicher und bekannter Flexodruckfarben für den Endlosdruck verwendet. Hierbei wurden exzellente Druckerzeugnisse in besonders hoher Auflage erhalten.

Während der Entwicklung der bildmäßig belichteten zugeschnittenen erfindungsgemäßen Aufzeichnungselemente wurde außerdem die Beladung der Abluft mit organischem Material gemessen und mit der abgesaugten Luftmenge pro Stunde multipliziert. Die sich hieraus ergebenden Emissionswerte lagen weit unterhalb gesetzlich vorgeschriebener Emissionsgrenzwerte.

Die verbrauchte Emulsion eines Feststoffgehalts von 5 Gew.-% konnte durch Destillation bei Normaldruck bei einer Temperatur zwischen 98 und 100°C nahezu vollständig aufgearbeitet werden. Hierbei wurden aus 60 l ursprünglich angewendeter Emulsion nahezu 53 l wiedergewonnen. Das Destillat war klar und bestand aus zwei Phasen. Das Volumenverhältnis von organischer Phase zu Wasser betrug 0,76. Nach Auffüllen der fehlenden 7 l entaromatisierten Testbenzins konnte das zweiphasige Gemisch nach dem Umpumpen erneut zum Entwickeln verwendet werden.

### Beispiel 2

Herstellung eines erfindungsgemäßen Aufzeichnungselements mit wasserlöslicher optisch transparenter Deckschicht (C) und seine Weiterverarbeitung zu einer flexographischen Reliefdruckplatte

Beispiel 1 wurde wiederholt, nur daß die Temperatur der Emulsion mit Hilfe eines Thermostaten während des Entwicklungsvorgangs auf 30°C konstant gehalten wurde. Bereits nach einer Auswaschzeit von jeweils nur 5 Minuten wurden flexographische Reliefdruckplatten erhalten, deren photopolymerisierte Reliefschichten eine Relieftiefe von 1200 µm aufwiesen. Die bei Beispiel 1 im Detail beschriebenen besonderen Vorteile wurden auch hier erhalten. Außerdem lag die bei dem Entwicklungsvorgang emittierte Lösungsmittelmenge mit 0,3 kg/h noch immer um eine Größenordnung niedriger als die gesetzlich vorgeschriebenen Emissionsgrenzwerte von 3 kg/h.

### Beispiel 3

Herstellung eines erfindungsgemäßen Aufzeichnungselements mit wasserlöslicher optisch transparenter Deckschicht (C) und seine Weiterverarbeitung zu einer flexographischen Reliefdruckplatte

Beispiel 1 wurde wiederholt, nur daß anstelle von Mowiol® 04 M1 das partiell hydrolysierte Vinylacetat-Ethylenoxid-Pfropfmischpolymerisat Mowiol®E 5-97 der Fa. Hoechst verwendet wurde, die optisch transparente Deckschicht (C) 2 µm dick war und die Deckfolie (D) eine glatte Oberfläche aufwies.

Es wurden die selben Vorteile wie in Beispiel 1 erhalten, nur daß die Oberfläche der deckfolienfreien zugeschnittenen erfindungsgemäßen Aufzeichnungselemente völlig glatt war, so daß jeder noch so kleine Fehler in der Oberfläche sofort hätte erkannt werden können. Indes waren keinerlei Oberflächenfehler vorhanden.

### Vergleichsversuch 1

Herstellung eines bekannten lichtempfindlichen Aufzeichnungselements mit einer in organischen Lösungsmitteln löslichen optisch transparenten Deckschicht (C) und seine Weiterverarbeitung zu einer flexographischen Reliefdruckplatte in bekannter Weise

Beispiel 1 wurde wiederholt, nur daß anstelle der dort verwendeten wasserlöslichen optisch transparenten Deckschicht (C) eine 5 µm starke optisch transparente Deckschicht (C) aus dem alkohollöslichen Polyamid Macromelt® 6900 der Fa. Henkel verwendet wurde und die deckfolienfreien zugeschnittenen bekannten lichtempfindlichen Aufzeichnungselemente nach ihrer bildmäßigen Belichtung mit aktinischem Licht mit dem üblichen und bekannten organischen Lösungsmittelgemisch Tetrachlorethylen/n-Butanol (Volumenverhältis 8:2) entwickelt wurden.

Im Vergleich zu den erfindungsgemäßen Aufzeichnungselementen der Beispiele 1 bis 3 wies das bekannte lichtempfindliche Aufzeichnungselement zahlreiche Nachteile auf: So hatte die Deckfolie (D) eine sehr viel schlechtere Haftung zu der optisch transparenten Deckschicht (C), so daß sie sich beim Zuschneiden des bekannten lichtempfindlichen Aufzeichnungselements bis zu 1 cm vom Rand entfernt ablöste. Die optisch transparente Deckschicht (C) selbst bildete beim Biegen des bekannten lichtempfindlichen Aufzeichnungselements oder der zugeschnittenen bekannten lichtempfindlichen Aufzeichnungselemente eine starke, deutlich sichtbare Struktur in ihrer Oberfläche aus.

Das Lösungsmittelgemisch besaß einen unangenehmen Geruch und war außerdem toxisch, so daß eine aufwendige Belüftung des Trommelbürstenwaschers und eine Reinigung der Abluft notwendig waren. Außerdem lag der Flammpunkt nach DIN 51 755 des Lösungsmittelgemischs mit 51°C 10°C tiefer als bei der Emulsion der Beispiele 1 bis 3, so daß bei seiner Handhabung Vorsicht geboten war. Darüber hinaus überschritten die emittierten Lösungsmittelmengen mit 3 kg/h die gesetzlich vorgeschriebenen Emissionsgrenzwerte von 0,3 kg/h um das 10fache. Zwar konnte das Entwicklerlösungsittel durch Destillation bei Normaldruck wieder aufgearbeitet werden, aber dies konnte nicht die vorstehend genannten Nachteile kompensieren.

Die in dieser Weise erhaltenen flexographischen Reliefdruckplatten besaßen außerdem einen äußerst unangenehmen Geruch und die druckende Oberfläche ihrer photopolymerisierten Reliefschichten wies eine starke Orangenhaut auf. Diese Nachteile konnten auch nicht durch die Tatsache wettgemacht werden, daß die photoplymerisierten Reliefschichten bereits nach einer Entwicklungszeit von 10 Minuten eine Relieftiefe von 1400 µm aufwiesen.

### Beispiel 4

Herstellung eines erfindungsgemäßen Aufzeichnungselements mit wasserlöslicher optisch transparenter Deckschicht (C) und seine Weiterverarbeitung zu einer flexographischen Reliefdruckplatte

Beispiel 1 wurde wiederholt, nur daß anstelle der dort beschriebenen Emulsion eine Wasser-in-Öl-Emulsion aus 29 l Tetrachlorethylen, 1 l Limonen und 30 l Wasser für die Entwicklung verwendet wurde. Deswegen wurden die bei Beispiel 1 im Detail beschriebenen Vorteile auch hier erhalten, wogegen die Nachteile des Vergleichsversuchs 1 nicht auftraten.

Darüber hinaus zeigte es sich, daß sich das Desorbat aus den Aktivkohlefiltern der Abluftreinigungsanlage des Trommelbürstenwaschers nach kurzer Standzeit wieder in die organische und die wäßrige Phase auftrennte, so daß das Tetrachlorethylen leicht abgetrennt und entsorgt oder wiederverwendet werden konnte.

### Beispiel 5

Herstellung eines erfindungsgemäßen Aufzeichnungselements mit wasserlöslicher optisch transparenter Deckschicht (C) und seine Weiterverarbeitung zu einer flexographischen Reliefdruckplatte

Beispiel 1 wurde wiederholt, nur daß die photopolymerisierbare reliefbildende Aufzeichnungsschicht (B) statt aus den bei Beispiel 1 angegebenen Bestandteilen (b₁), (b₂), (b₃) und (b₄) aus
- 80 kg des Ethylen-Propylen-Alkadien-Kautschuks Buna® AP 241 der Firma Hüls GmbH (Ethylengehalt 50 Gew.%; Doppelbindungsanteil: 8 Doppelbindungen je 1000 Kohlenstoffatome) (b₁),
- 1 kg Benzildimethylacetal (b₂),
- 5 kg Isobornylacrylat (b₃),
- 5 kg Dihydrocyclopentadienylacrylat (b₃),
- 5 kg Adipinsäure-di-n-octylester (b₄),
- 0,01 kg Siccoflush D (C.I. 74260) und
- 0,5 kg 2,6-Di-tert.-butyl-p-kresol

hergestellt worden war.

Auch hier wurden die bei Beispiel 1 im Detail beschriebenen Vorteile erhalten. Auffallend war die besonders gute Haftung der optisch transparenten Deckschicht (C) an der photopolymerisierbaren reliefbildenden Aufzeichnungsschicht (B), die vorteilhaft kurze Zeit von nur 5 Minuten, in welcher die bildmäßig belichteten zugeschnittenen erfindungsgemäßen Aufzeichnungselemente bis zu einer Relieftiefe von 1200 µm ausgewaschen werden konnten, und die überaus hohe Beständigkeit der in dieser Weise erhaltenen flexographischen Reliefdruckplatten gegenüber Essigester oder Ketone enthaltenden Flexodruckfarben.

### Beispiel 6

Die Herstellung eines erfindungsgemäßen Aufzeichnungselements, dessen photopolymerisierbare Aufzeichnungsschicht (B) aus zwei Einzelschichten (B) unterschiedlicher Löslichkeitseigenschaften besteht und das eine in organischen Lösungsmitteln lösliche oder quellbare optisch transparente Deckfolie (C) enthält, sowie seine Weiterverarbeitung zu einer flexographischen Reliefdruckplatte

Das erfindungsgemäße Aufzeichnungselement wurde in der nachstehend beschriebenen Weise durch Coextrusion hergestellt.

Das der Herstellung der Einzelschicht (B₁) dienende photopolymerisierbare Gemisch (b₁) bestand aus 81,8 Gew.% eines Dreiblockkautschuks des Aufbaus Styrol/Isopren/Styrol (Cariflex® 1107 der Shell AG), 1,2 Gew.% Benzildimethylacetal (b₂), 2,0 Gew.% 2,6-Di-tert.-butyl-p-kresol (b₄), 5,0 Gew.% 1,6-Hexandioldiacrylat (b₃) und 10,0 Gew.% Paraffinöl (Weißöl S 5000, b₄). Das photopolymerisierbare Gemisch (B₁1) wurde in üblicher und bekannter Weise auf einem Zweiwellenentgasungsextruder hergestellt und hierin als geschmolzener Stoffstrom (B₁) zu einer Zweischichtendüse transportiert. Hierbei lag die maximale Temperatur des geschmolzenen Stoffstroms (B₁) bei 155°C, der Stoffdurchsatz war 30 kg/Stunde, und die Verweilzeit im Extruder lag bei 5 Minuten. Vor seinem Entritt von unten in eine Zweischichtendüse passierte der geschmolzene Stoffstrom (B₁) ein 40 µm Metallgewebefilter.

Das der Herstellung der Einzelschicht (B₂) dienende photopolymerisierbare Gemisch (B₂) bestand aus 71,497 Gew.% eines Terpolymeren aus 58 Gew.% Ethylen, 21 Gew.% Acrylsäure und 21 Gew.% 2-Ethylhexylacrylat (b₁), 6 Gew.% Glycidylmethacrylat (b₃), 15 Gew.% N-n-Butylbenzolsulfonsäureamid (Cetamoll® BMB der BASF AG, b₄), 5 Gew.% Butylethanolamin (b₄), 1,2 Gew.% Benzildimethylacetal (b₂), 0,8 Gew.% N-Nitroso-N-cyclohexylhydroxylaminkaliumsalz (b₄) kombiniert mit 0,003 Gew.% Safranin T (C.I. 50240) (b₄) und 0,5 Gew.% 2,6-Di-tert.-butyl-p-kresol (b₄). Es wurde separat vom photopolymerisierbaren Gemisch (B₁) auf einem Zweiwellenentgasungsextruder hergestellt und als geschmolzener Stoffstrom (B₂) zur Zweischichtendüse transportiert. Hierbei lag die maximale Temperatur des geschmolzenen Stoffstroms (B₂) bei 140°C, der Stoffdurchsatz war 10 kg/Stunde, und die Verweilzeit im Extruder lag bei 7 Minuten. Vor seinem Eintritt in die Zweischichtendüse von oben passierte der geschmolzene Stoffstrom (B₂) ein 40 µm Metallgewebefilter.

Die Schmelzflußindices der Stoffströme (B₁) und (B₂) wurden separat in üblicher und bekannter Weise unter einem Gewicht von 0,6 kg nach DIN 53735 bestimmt. Hierbei erwies sich der Stoffstrom (B₁) mit einem Schmelzflußindex bei 150°C von 2 g/10 Minuten als höherviskos als der Stoffstrom (B₂) mit einem Schmelzflußindex bei 150°C von 100 g/10 Minuten. Der Stoffstrom (B₂) wies demnach einen um den Faktor 50 höheren Schmelzflußindex auf als der Stoffstrom (B₁).

Die beiden geschmolzenen Stoffströme (B₁) und (B₂) wurden in der Zweischichtendüse zusammengeführt, wobei der geschmolzene Stoffstrom (B₁) von unten und der geschmolzene Stoffstrom (B₂) von oben her eingespeist wurde. Die beiden Stoffströme (B₁) und (B₂) wurden als übereinanderliegende geschmolzene flächige Gebilde (B₁) und (B₂) der Breite 33,5 cm bei einer Düsentemperatur von 145°C ausgetragen und hiernach unmittelbar in den Spalt eines Kalanders eingeführt, wobei das niedriger viskose geschmolzene flächige Gebilde (B₂) den Massewulst ausbildete. Die Verweilzeit zwischen dem Zusammenführen der übereinanderliegenden geschmolzenen flächigen Gebilde (B₁) und (B₂) und dem Entritt in den Kalanderspalt lag bei 30 Sekunden. Die Temperatur der Kalanderwalzen lag bei 80°C.

Zusammen mit den übereinanderliegenden geschmolzenen flächigen Gebilden (B₁) und (B₂) wurden auf der Seite des flächigen Gebildes (B₁) eine mit einem Haftlack beschichtete Trägerfolie (dimensionsstabiler Träger A) und auf der Seite des flächigen Gebildes (B₂) eine mit einer Deckschicht (C) beschichtete Deckfolie (D) in den Kalanderspalt eingeführt. Hierbei wurden als Deck- und Trägerfolien 125 µm starke biaxial gereckte Polyethylenterephthalatfolien verwendet. In ihrer Funktion als Deckfolie (D) waren sie einseitig mit einer 5 µm starken Schicht aus einem üblichen und bekannten Cyclokautschuk hohen Cyclisierungsgrades (Deckschicht C) beschichtet. In ihrer Funktion als Trägerfolie (A) waren sie einseitig mit einer 5 µm starken Polyurethanhaftlackschicht versehen.

Beim Kalandrieren im Kalanderspalt wurden die übereinanderliegenden geschmolzenen flächigen Gebilde (B₁) und (B₂) zu der 2100 µm dicken Einzelschicht (B₁) und zu der 700 µm dicken Einzelschicht (B₂) geformt, wobei die beiden Einzelschichten (B₁) und (B₂) zugleich haftfest miteinander zu der photopolymerisierbaren Aufzeichnungsschicht (B) verbunden wurden. Insgesamt resultierte das erfindungsgemäße Aufzeichnungselement, in welchem die 125 µm dicke Trägerfolie (A), die 5 µm dicke Haftlackschicht, die 2100 µm dicke Einzelschicht (B₁), die 700 µm dicke Einzelschicht (B₂), die Deckschicht (C) und die Deckfolie (D) in der angegebenen Reihefolge übereinanderlagen, wobei die beiden Einzelschichten (B₁) und (B₂) zusammen die photopolymerisierbare Aufzeichnungsschicht (B) bildeten.

Das erfindungsgemäße Aufzeichnungselement konnte problemlos formatgerecht zugeschnitten werden, ohne daß es hierbei zum Ablösen der Deckschicht (C) von der obersten Einzelschicht (B₂) oder zur Trennung der Deckfolie (D) von der Deckschicht (C) kam. Die Deckfolien (D) konnten von den Deckschichten (C) der zugeschnittenen erfindungsgemäßen Aufzeichnungselemente abgezogen werden, ohne daß es hierbei zu einer Beschädigung der Deckschichten (C) und zu einer merklichen elektrostatischen Aufladung kam. Beim Biegen der deckfolienfreien zugeschnittenen erfindungsgemäßen Aufzeichnungselemente blieb deren optisch transparente Deckschicht (C) unverletzt; es trat nur eine sehr feine Strukturierung auf.

Die deckfolienfreien zugeschnittenen erfindungsgemäßen Aufzeichnungselemente wurden, wie bei Beispiel 1 beschrieben, zu flexographischen Reliefdruckplatten weiterverarbeitet, nur daß anstelle der Wasser-in-Öl-Emulsion des Beispiels 1 eine Öl-in-Wasser-Emulsion verwendet wurde. Diese Öl-in-Wasser-Emulsion bestand aus 30 l des entaromatisierten Testbenzins des Beispiels 1 als fein dispergierter organischer Phase, 30 l wäßriger 1 %iger Natriumcarbonatlösung als kontinuierlicher wäßriger Phase und aus, bezogen auf die Emulsion, 0,1 Gew.% des Emulgators Natriumdodecylhydrogensulfat.

Überraschenderweise konnten mit Hilfe der Öl-in-Wasser-Emulsion die bildmäßig belichteten zugeschnittenen erfindungsgemäßen Aufzeichnungselemente innerhalb 10 Minuten bis zu einer Relieftiefe von 1500 µm ausgewaschen werden. Außerdem wies die druckende Oberfläche der photopolymerisierten Reliefschichten der so erhaltenen flexographischen Reliefdruckplatten weder Reste von Deckschichtmaterial (D) oder eine Orangenhaut auf und war frei von Tropfnasen. Dies bedeutete, daß sowohl die in organischen Lösungsmitteln lösliche oder quellbare Deckschicht (C) aus Cyclokautschuk als auch die mit wäßrigen Lösungsmitteln entwickelbaren nicht belichteten Bereiche der Einzelschicht (B₂) und die mit organischen Lösungsmitteln entwickelbaren nicht belichteten Bereiche der Einzelschicht (B₁) in einem Arbeitsgang ausgewaschen worden waren.

Ansonsten wiesen die in dieser Weise hergestellten flexographischen Reliefdruckplatten ein außergewöhnlich gutes Druckverhalten auf und lieferten exzellente vorlagengetreue Druckerzeugnisse in hoher Auflage.

Die verbrauchte Emulsion konnte, ebenso wie die des Beispiels 1, durch Destillation unter Normaldruck aufgearbeitet und hiernach nach Zugabe des Emulgators wiederverwendet werden.

### Vergleichsversuch 2

Die Herstellung eines nicht erfindungsgemäßen lichtempfindlichen Aufzeichnungselements, dessen photopolymerisierbare reliefbildende Aufzeichnungsschicht (B) aus zwei Einzelschichten (B) unterschiedlicher Löslichkeitseigenschaften besteht und das eine wasserlöslich optisch transparente Deckschicht (C) enthält, sowie seine Weiterverarbeitung zu einer flexographischen Reliefdruckplatte nach einem bekannten Verfahren

Beispiel 6 wurde wiederholt, nur daß anstelle der Deckschicht (C) aus Cyclokautschuk eine Deckschicht (C) aus dem Vinylacetat-Ethylenoxid-Pfropfmischpolymerisat Mowiol® 04-M1 der Fa. Hoechst verwendet wurde und die Entwicklung mit 60 l wäßriger 1 %iger Natriumcarbonatlösung durchgeführt wurde.

Hierbei zeigte es sich, daß die bildmäßig belichteten zugeschnittenen lichtempfindlichen Aufzeichnungselemente nur bis zu einer Relieftiefe von 700 µm, d.h. bis zu der mit organischen Lösungsmitteln entwickelbaren Einzelschicht (B₁) hin, ausgewaschen werden konnten. Die nicht belichteten Bereiche der Einzelschicht (B₁) waren nach wie vor zugegen, und die entwickelten Aufzeichnungselemente waren ohne zusätzliche Verarbeitungsschritte für den Flexodruck nicht verwendbar.

### Beispiel 7

Die Herstellung eines nicht erfindungsgemäßen lichtempfindlichen Aufzeichnungselements, dessen photopolymerisierbare reliefbildende Aufzeichnungsschicht (B) aus zwei Einzelschichten (B) unterschiedlicher Löslichkeitseigenschaften besteht und das eine wasserlösliche optisch transparente Deckschicht (C) enthält, sowie seine Weiterverarbeitung zu einer flexographischen Reliefdruckplatte nach dem erfindungsgemäßen Verfahren

Vergleichsversuch 2 wurde wiederholt, nur daß anstelle der wäßrigen 1 %igen Natriumcarbonatlösung die Öl-in-Wasser-Emulsion des Beispiels 6 verwendet wurde.

Hierbei konnten sowohl die Deckschicht (C) als auch die mit wäßrigen Lösungsmitteln entwickelbaren nicht belichteten Bereiche der Einzelschicht (B₂) und die mit organischen Lösungsmitteln entwickelbaren nicht belichteten Bereiche der Einzelschicht (B₁) in einem Arbeitsgang ausgewaschen werden, wobei bereits nach 10minütiger Auswaschzeit eine Relieftiefe von 1500 µm erzielt wurde.

Die in dieser Weise hergestellten flexographischen Reliefdruckplatten wiesen eine vorzüglich druckende Oberfläche auf und konnten für den Flexodruck verwendet werden, ohne daß zusätzliche Entwicklungsschritte notwendig waren.

## Patentansprüche

1. Lichtempfindliches Aufzeichnungselement für die Herstellung einer flexographischen Reliefdruckplatte mit einem dimensionsstabilen Träger (A), einer 0,1 bis 7 mm dicken photopolymerisierbaren reliefbildenden Aufzeichnungsschicht (B), welche aus einer einzigen schicht (B) oder aus mindestens zwei Einzelschichten (B) besteht und in welcher bei der bildmäßigen Belichtung mit aktinischem Licht eine Löslichkeitsdifferenzierung zwischen ihren belichteten und unbelichteten Bereichen eintritt, so daß ihre unbelichteten Bereiche insgesamt oder die unbelichteten Bereiche ihrer obersten Einzelschicht (B) mit einem bestimmten Lösungsmittel ausgewaschen (entwickelt) werden können, und einer an der Oberfläche von (B) fest haftenden optisch transparenten Deckschicht (C), dadurch gekennzeichnet, daß die optisch transparente Deckschicht (C) in dem Lösungsmittel für die unbelichteten Bereiche der Aufzeichnungsschicht (B) nicht löslich oder quellbar ist.

2. Das lichtempfindliche Aufzeichnungselement nach Anspruch 1, dadurch gekennzeichnet, daß die nicht belichteten Bereiche in Wasser oder wäßrigen Lösungsmitteln löslich oder quellbar sind, wogegen die optisch transparente Deckschicht (C) in organischen Lösungsmittel löslich oder quellbar ist.

3. Das lichtempfindliche Aufzeichnungselement nach Anspruch 1, dadurch gekennzeichnet, daß die nicht belichteten Bereiche in organischen Lösungsmitteln löslich oder quellbar sind, wogegen die optisch transparente Deckschicht (C) in Wasser oder wäßrigen Lösungsmitteln löslich oder quellbar ist.

4. Das lichtempfindliche Aufzeichnungselement nach Anspruch 3, dadurch gekennzeichnet, daß die photopolymerisierbare reliefbildende Aufzeichnungsschicht (B) oder ihre oberste Einzelschicht (B) aus
(b₁) 20 bis 99 Gew.-% mindestens eines in organischen Lösungsmitteln löslichen oder quellbaren Elastomeren als Bindemittel,
(b₂) 0,001 bis 10 Gew.-% mindestens eines Photopolymerisationsinitiators,
(b₃) 1 bis 60 Gew.-% mindestens eines photopolymerisierbaren Monomeren, welches mit dem oder den Elastomeren (b₁) verträglich ist, und
(b₄) 0 bis 40 Gew.-% mindestens eines Hilfsstoffes
besteht und daß die optisch transparente Deckschicht (C) hauptsächlich oder insgesamt aus partiell oder nahezu vollständig hydrolysierten Poly(vinylalkoholalkancarbonsäureestern), partiell oder nahezu vollständig hydrolysierten Vinylalkoholalkancarbonsäureester-Alkylenoxid-Pfropfmischpolymerisaten, Gelatine, Celluloseethern, Celluloseestern, Polyvinylpyrrolidon, Vinylaromat-Alkendicarbonsäureanhydrid-Copolymerisaten, Vinylether-Alkendicarbonsäureanhydrid-Copolymerisaten, Poly(meth)acrylsäure, (Meth)Acrylsäure-(Meth)Acrylat-Copolymerisaten, Polyalkylenoxiden, Saponinen und/oder Sacchariden besteht, welche in Wasser und/oder wäßrigen Lösungsmitteln löslich oder quellbar sind.

5. Das lichtempfindliche Aufzeichnungselement nach Anspruch 3 oder 4, dadurch gekennzeichnet, daß es sich bei den Elastomeren (b₁) um Polyalkadiene, Vinylaromat-Alkadien-Copolymerisate, Vinylaromat-Alkadien-Blockmischpolymerisate, Alkadien-Acrylnitril-Copolymerisate, Butylkautschuke, Acrylatkautschuke, Polychloroprene, Fluorkautschuke, silikonkautschuke, Polysulfidkautschuke oder um Ethylen-Propylen-Alkadien-Copolymerisate handelt.

6. Das lichtempfindliche Aufzeichnungselement nach einem der Ansprüche 3 bis 5, dadurch gekennzeichnet, daß es sich bei den Elastomeren (b₁) um Polyalkadiene, Vinylaromat-Alkadien-Copolymerisate, Vinylaromat-Alkadien-Blockmischpolymerisate, Alkadien-Acrylnitril-Copolymerisate oder um Ethylen-Propylen-Alkadien-Copolymerisate handelt und daß die optisch transparente Deckschicht (C) hauptsächlich oder insgesamt aus partiell oder nahezu vollständig hydrolysierten Poly(vinylalkoholalkancarbonsäureestern) und/oder partiell oder nahezu vollständig hydrolysierten Vinylalkoholalkancarbonsäureester-Alkylenoxid-Pfropfmischpolymerisaten besteht.

7. Das lichtempfindliche Aufzeichnungselement nach Anspruch 2, dadurch gekennzeichnet, daß die photopolymerisierbare reliefbildende Aufzeichnungsschicht (B) oder ihre oberste Einzelschicht (B) aus
(b₁) 20 bis 99 Gew.-% mindestens eines in Wasser oder in wäßrigen Lösungsmitteln löslichen oder quellbaren Elastomeren als Bindemittel,
(b₂) 0,001 bis 10 Gew.-% mindestens eines Photopolymerisationsinitiators,
(b₃) 1 bis 60 Gew.-% mindestens eines photopolymerisierbaren Monomeren, welches mit dem oder den Elastomeren (b₁) verträglich ist, und
(b₄) 0 bis 40 Gew.-% mindestens eines Hilfsstoffes
besteht und daß die optisch transparente Deckschicht (C) hauptsächlich oder insgesamt aus Polyamiden, Copolyamiden, Polyethylen, Ethylen-Propylen-Copolymerisaten, Polystyrol, Styrol-Acrylnitril-Copolymerisaten, Poly(meth)acrylaten, Ethylen-Vinylacetat-Copolymerisaten, Polyvinylchlorid, Vinylchlorid-Vinylacetat-Copolymerisaten, Polycarbonaten, Silikonkautschuken, Polyestern, Polyurethanen oder Cyclokautschuken hohen Cyclisierungsgrades besteht.

8. Das lichtempfindliche Aufzeichnungselement nach Anspruch 2 oder 7, dadurch gekennzeichnet, daß es sich bei den Elastomeren (b₁) um Ethylen-(Meth)Acrylsäure-Copolymerisate, partiell oder nahezu vollständig hydrolysierte Poly(vinylalkoholalkancarbonsäureester), partiell oder nahezu vollständig hydrolysierte Vinylalkoholalkancarbonsäureester-Alkylenoxid-Pfropfmischpolymerisate, maleinierte Alkadienpolymerisate, durch Maleinierung und Teilveresterung oder Teilamidierung polymeranalog modifizierte Alkadienpolymerisate, Copolymerisate von Alkadienen mit α,β-ungesättigten Carbonsäuren oder um carboxylgruppenhaltige Alkadien-Acrylnitril-Copolymerisate handelt.

9. Das lichtempfindliche Aufzeichnungselement nach einem der Ansprüche 2, 7 oder 8, dadurch gekennzeichnet, daß es sich bei den Elastomeren (b₁) um Ethylen-(Meth)Acrylsäure-Copolymerisate handelt, welche mindestens ein weiteres Comonomeres aus der Gruppe der Vinylester, der Vinylether, Acrylsäureester, Methacrylsäureester, Acrylamide und Methacrylamide einpolymerisiert enthalten, und daß die optisch transparente Deckschicht (C) hauptsächlich oder insgesamt aus einem Polyamid besteht.

10. Verfahren zur Herstellung einer flexographischen Reliefdruckplatte mit einer photopolymerisierten Reliefschicht aus einem lichtempfindlichen Aufzeichnungselement, welches einen dimensionsstabilen Träger (A), eine photopolymerisierbare reliefbildende Aufzeichnungsschicht (B), welche aus einer einzigen Schicht (B) oder aus mindestens zwei Einzelschichten (B) besteht, und eine an der Oberfläche von (B) fest haftende optisch transparente Deckschicht (C) enthält, durch
(1) bildmäßiges Belichten der photopolymerisierbaren reliefbildenden Aufzeichnungsschicht (B) mit aktinischem Licht, wodurch in der Aufzeichnungsschicht (B) eine Löslichkeitsdifferenzierung zwischen den belichteten und unbelichteten Bereichen eintritt, und
(2) Auswaschen (Entwickeln) der optisch transparenten Deckschicht (C) und der nicht belichteten und daher nicht photopolymerisierten Bereiche der bildmäßig belichteten reliefbildenden Aufzeichnungsschicht (B) mit einem Lösungsmittel unter Bildung der photopolymerisierten Reliefschicht,
dadurch gekennzeichnet, daß man hierbei ein lichtempfindliches Aufzeichnungselement gemäß einem der Ansprüche 1 bis 9 verwendet und daß man das Entwickeln (Verfahrensschritt 2) mit einer Emulsion in einem Arbeitsgang durchführt.

11. Verfahren nach Anspruch 10, dadurch gekennzeichnet, daß die photopolymerisierbare reliefbildende Aufzeichnungsschicht (B) mindestens zwei Einzelschichten (B) unterschiedlicher Löslichkeitseigenschaften umfasst und daß man hierbei im Verfahrensschritt (2) die unbelichteten Bereiche von mindestens zwei der Einzelschichten (B) unterschiedlicher Löslichkeitseigenschaften zusammen mit der optisch transparenten Deckschicht (C) in einem Arbeitsgang mit einer Emulsion auswäscht (entwickelt).

12. Das Verfahren nach Anspruch 11, dadurch gekennzeichnet, daß man hierbei ein lichtempfindliches Aufzeichnungselement verwendet, dessen optisch transparente Deckschicht (C) und dessen unmittelbar unter (C) liegende Einzelschicht (B) in organischen Lösungsmitteln löslich oder quellbar sind.

13. Das Verfahren nach Anspruch 11, dadurch gekennzeichnet, daß man hierbei ein lichtempfindliches Aufzeichnungselement verwendet, dessen optisch transparente Deckschicht (C) und dessen unmittelbar unter (C) liegende Einzelschicht (B) in Wasser oder wäßrigen Lösungsmitteln löslich oder quellbar sind.

14. Das Verfahren nach einem der Ansprüche 10 bis 13, dadurch gekennzeichnet, daß man eine Emulsion vom Typ "Wasser-in-Öl" verwendet, welche eine fein dispergierte wäßrige Phase und eine kontinuierliche nicht brennbare oder schwer brennbare und/oder hochsiedende organische Phase im Volumenverhältnis von 90:10 bis 10:90 enthält.

15. Das Verfahren nach einem der Ansprüche 10 bis 13, dadurch gekennzeichnet, daß man hierbei eine Emulsion vom Typ "Öl-in-Wasser" verwendet, welche eine fein dispergierte organische Phase und eine kontinuierliche wäßrige Phase im Volumenverhältnis von 90:10 bis 10:90 enthält.

16. Das Verfahren nach Anspruch 15, dadurch gekennzeichnet, daß man hierbei eine nicht brennbare oder schwer brennbare und/oder hochsiedende organische Phase verwendet.

17. Das Verfahren nach Anspruch 14, dadurch gekennzeichnet, daß man hierbei ein lichtempfindliches Aufzeichnungselement gemäß einem der Ansprüche 3 bis 6 verwendet.

18. Das Verfahren nach Anspruch 15, dadurch gekennzeichnet, daß man hierbei ein lichtempfindliches Aufzeichnungselement gemäß einem der Ansprüche 2 bis 7 bis 9 verwendet.

19. Das Verfahren nach einem der Ansprüch 15 bis 18, dadurch gekennzeichnet, daß die organische Phase chlorierte Kohlenwasserstoffe, aromatische Kohlenwasserstoffe, gesättigte und/oder ungesättigte cyclische und/oder acyclische Kohlenwasserstoffe, Petroleumdestillate, hydrierte Erdölfraktionen und/oder deren Gemische enthält oder hieraus besteht.

## Claims

1. A photosensitive recording element for the production of a flexographic relief printing plate, having a dimensionally stable substrate (A), a 0.1 to 7 mm thick photopolymerizable relief-forming recording layer (B), which consists of a single layer (B) or of two or more individual layers (B), and in which a difference between the solubilities of its exposed and unexposed parts arises during imagewise exposure to actinic light, so that its unexposed parts all together or the unexposed parts of its uppermost individual layer (B) can be washed out (developed) with a certain solvent, and of an optically transparent top layer (C) firmly adhering to the surface of (B), wherein said layer (C) is not soluble or swellable in the solvent for the unexposed parts of the recording layer (B).

2. A photosensitive recording element as claimed in claim 1, wherein the unexposed parts are soluble or swellable in water or aqueous solvents whereas the optically transparent top layer (C) is soluble or swellable in organic solvents.

3. A photosensitive recording element as claimed in claim 1, wherein the unexposed parts are soluble or swellable in organic solvents whereas the optically transparent top layer (C) is soluble or swellable in water or aqueous solvents.

4. A photosensitive recording element as claimed in claim 3, wherein the photopolymerizable relief-forming recording layer (B) or its uppermost individual layer (B) consists of
(b₁) from 20 to 99% by weight of one or more elastomers which are soluble or swellable in organic solvents, as binders,
(b₂) from 0.001 to 10% by weight of one or more photopolymerization initiators,
(b₃) from 1 to 60% by weight of one or more photopolymerizable monomers which are compatible with the elastomer or elastomers (b₁) and
(b₄) from 0 to 40% by weight of one or more assistants,
and the optically transparent top layer (C) consists mainly or entirely of partially or virtually completely hydrolyzed poly(vinyl alkanecarboxylates), partially or virtually completely hydrolyzed vinyl alkanecarboxylate/alkylene oxide graft copolymers, gelatine, cellulose ethers, cellulose esters, polyvinylpyrrolidone, vinyl aromatic/alkenedicarboxylic anhydride copolymers, vinyl ether/alkenedicarboxylic anhydride copolymers, poly(meth)acrylic acid, (meth)acrylic acid/(meth)acrylate copolymers, polyalkylene oxides, saponines and/or saccharides, which are soluble or swellable in water and/or aqueous solvents.

5. A photosensitive recording element as claimed in claim 3 or 4, wherein the elastomers (b₁) are polyalkadienes, vinyl aromatic/alkadiene copolymers, vinyl aromatic/alkadiene block copolymers, alkadiene/acrylonitrile copolymers, butyl rubbers, acrylate rubbers, polychloroprenes, fluorine rubbers, silicone rubbers, polysulfide rubbers or ethylene/propylene/alkadiene copolymers.

6. A photosensitive recording element as claimed in claim 3 or 4 or 5, wherein the elastomers (b₁) are polyalkadienes, vinyl aromatic/alkadiene copolymers, vinyl aromatic/alkadiene block copolymers, alkadiene/acrylonitrile copolymers or ethylene/propylene/alkadiene copolymers, and the optically transparent top layer (C) consists mainly or entirely of partially or virtually completely hydrolyzed poly(vinyl alkanecarboxylates) and/or partially or virtually completely hydrolyzed vinyl alkanecarboxylate/alkylene oxide graft copolymers.

7. A photosensitive recording element as claimed in claim 2, wherein the photopolymerizable relief-forming recording layer (B) or its uppermost individual layer (B) consists of
(b₁) from 20 to 99% by weight of one or more elastomers which are soluble or swellable in water or aqueous solvents, as binders,
(b₂) from 0.001 to 10% by weight of one or more photopolymerization initiators,
(b₃) from 1 to 60% by weight of one or more photopolymerizable monomers which are compatible with the elastomer or elastomers (b₁) and
(b₄) from 0 to 40% by weight of one or more assistants,
and the optically transparent top layer (C) consists mainly or entirely of polyamides, copolyamides, polyethylene, ethylene/propylene copolymers, polystyrene, styrene/acrylonitrile copolymers, poly(meth)acrylates, ethylene/vinyl acetate copolymers, polyvinyl chloride, vinylchloride/vinyl acetate copolymers, polycarbonates, silicone rubbers, polyesters, polyurethanes or cyclized rubbers having a high degree of cyclization.

8. A photosensitive recording element as claimed in claim 2 or 7, wherein the elastomers (b₁) are ethylene/(meth)acrylic acid copolymers, partially or virtually completely hydrolyzed poly(vinyl alkanecarboxylates), partially or virtually completely hydrolyzed vinyl alkanecarboxylate/alkylene oxide graft copolymers, maleated alkadiene polymers, alkadiene polymers modified by maleation and partial esterification or partial amidation in polymer-analogous reactions, copolymers of alkadienes which α,β-unsaturated carboxylic acids or carboxyl-containing alkadiene/acrylonitrile copolymers.

9. A photosensitive recording element as claimed in claim 2 or 7 or 8, wherein the elastomers (b₁) are ethylene/(meth)acrylic acid copolymers which contain one or more further comonomers from the group consisting of the vinyl esters, the vinyl ethers, acrylates, methacrylates, acrylamides and methacrylamides as polymerized units, and the optically transparent top layer (C) consists mainly or entirely of polyamide.

10. A process for the production of a flexographic relief printing plate having a photopolymerized relief layer from a photosensitive recording element which contains a dimensionally stable substrate (A), a photopolymerizable relief-forming recording layer (B), which consists of a single layer (B) or of two or more individual layers (B), and an optically transparent top layer (C) firmly adhering to the surface of (B), by
(1) imagewise exposure of the photopolymerizable relief-forming recording layer (B) to actinic light, with the result that there is a difference between the solubilities of the exposed and unexposed parts in the recording layer (B), and
(2) washout (development) of the optically transparent top layer (C) and of the unexposed and therefore non-photopolymerized parts of the imagewise exposed relief-forming recording layer (B) with a solvent with formation of the photopolymerized relief layer, wherein a photosensitive recording element as claimed in claim 1 or 2 or 3 or 4 or 5 or 6 or 7 or 8 or 9 is used and development (process step 2) is carried out in an emulsion in one operation.

11. A process as claimed in claim 10, wherein the photopolymerizable relief-forming recording layer (B) comprises two or more individual layers (B) having different solubility properties and wherein, in process step (2), the unexposed parts of two or more of the individual layers (B) having different solubility properties are washed out (developed) together with the optically transparent top layer (C) in one operation with an emulsion.

12. A process as claimed in claim 11, wherein a photosensitive recording element is used whose optically transparent top layer (C) and whose individual layer (B) directly underneath (C) are soluble or swellable in organic solvents.

13. A process as claimed in claim 11, wherein a photosensitive recording element is used whose optically transparent top layer (C) and whose individual layer (B) directly underneath (C) are soluble or swellable in water or aqueous solvents.

14. A process as claimed in claim 10 or 11 or 12 or 13, wherein an emulsion of the water-in-oil type is used which contains a finely dispersed aqueous phase and a continuous nonflammable or poorly flammable and/or high boiling organic phase in a volume ratio of from 90 : 10 to 10 : 90.

15. A process as claimed in claim 10 or 11 or 12 or 13, wherein an emulsion of the oil-in-water type is used which contains a finely dispersed organic phase and a continuous aqueous phase in a volume ratio of from 90 : 10 to 10 : 90.

16. A process as claimed in claim 15, wherein a nonflammable or poorly flammable and/or high boiling organic phase is used.

17. A process as claimed in claim 14, wherein a photosensitive recording element as claimed in claim 3 or 4 or 5 or 6 is used.

18. A process as claimed in claim 15, wherein a photosensitive recording element as claimed in claim 2 or 7 or 8 or 9 is used.

19. A process as claimed in claim 15 or 16 or 17 or 18, wherein the organic phase contains or consists of chlorohydrocarbons, aromatic hydrocarbons, saturated or unsaturated, cyclic or acyclic hydrocarbons, petroleum distillations, hydrogenated mineral oil fractions or mixtures thereof.

## Revendications

1. Elément d'enregistrement photosensible pour la fabrication de plaques d'impression flexographique en relief, comprenant un support à dimensions stables (A), une couche d'enregistrement photopolymérisable formant le relief (B), épaisse de 0,1 à 7 mm, consistant en une seule épaisseur (B) ou en au moins deux épaisseurs différentes (B) et dans laquelle, à l'exposition à la lumière actinique avec formation d'une image, il se produit une différence de solubilité entre les régions exposées et les régions non exposées, de sorte que l'on peut extraire par lavage (développer) à l'aide d'un solvant déterminé les régions non exposées dans leur ensemble ou les régions non exposées de l'épaisseur individuelle supérieure (B), et une couche de couverture (C) transparente, adhérant solidement à la surface de (B), caractérisé en ce que la couche de couverture transparente (C) n'est ni soluble, ni gonflable dans le solvant des régions non exposées de la couche d'enregistrement (B).

2. L'élément d'enregistrement photosensible selon la revendication 1, caractérisé en ce que les régions non exposées sont solubles ou gonflables dans l'eau ou les solvants aqueux alors que la couche de couverture transparente (C) est soluble ou gonflable dans les solvants organiques.

3. L'élément d'enregistrement photosensible selon la revendication 1, caractérisé en ce que les régions non exposées sont solubles ou gonflables dans les solvants organiques alors que la couche de couverture optique (C) est soluble ou gonflable dans l'eau ou les solvants aqueux.

4. L'élément d'enregistrement photosensible selon la revendication 3, caractérisé en ce que la couche d'enregistrement photopolymérisable formant le relief (B) ou son épaisseur individuelle supérieure (B) consiste en
(b1) 20 à 99 % en poids d'au moins un élastomère soluble ou gonflable dans les solvants organiques, qui sert de liant
(b2) 0,001 à 10 % en poids d'au moins un inducteur de photopolymérisation,
(b3) 1 à 60 % en poids d'au moins un monomère photopolymérisable compatible avec le ou les élastomères (b1) et
(b4) 0 à 40 % en poids d'au moins un produit auxiliaire,
et la couche de couverture transparente (C) consiste principalement ou en totalité en poly-(alcanoates d'alcools vinyliques) partiellement ou presque totalement hydrolysés, copolymères greffés alcanoate d'alcool vinylique-oxyde d'alkylène partiellement ou presque complètement hydrolysés, gélatine, éthers cellulosiques, esters cellulosiques, polyvinylpyrrolidone, copolymères composé vinylaromatique-anhydride d'acide alcènedicarboxylique, copolymères éther vinylique-anhydride d'acide alcène-dicarboxylique, acide poly(méth)acrylique, copolymères acide (méth)acrylique(méth)acrylate, oxydes de polyalkylène, saponine et/ou saccharides, qui sont solubles ou gonflables dans l'eau et/ou les solvants aqueux.

5. L'élément d'enregistrement photosensible selon la revendication 3 ou 4, caractérisé en ce que les élastomères (b1) sont des polyalcadiènes, des copolymères composé vinylaromatique-alcadiène, des copolymères séquencés composé vinylaromatique-alcadiène, des copolymères alcadiène-acrylonitrile, des caoutchoucs Butyls, des caoutchoucs d'acrylates, des polychloroprènes, des caoutchoucs fluorés, des caoutchoucs de silicones, des caoutchoucs de polysulfures ou des copolymères éthylène-propylène-alcadiène.

6. L'élément d'enregistrement photosensible selon une des revendications 3 à 5, caractérisé en ce que les élastomères (b1) sont des polyalcadiènes, des copolymères composé vinylaromatique-alcadiène, des copolymères séquencés composé vinylaromatique-alcadiène, des copolymères alcadiène-acrylonitrile ou des copolymères éthylène-propylène-alcadiène et la couche de couverture transparente (C) consiste principalement ou en totalité en poly-(alcanoates d'alcools vinyliques) partiellement ou presque totalement hydrolysés et/ou copolymères greffés alcanoate d'alcools vinylique-oxyde d'alkylène partiellement ou presque complètement hydrolysés.

7. L'élément d'enregistrement photosensible selon la revendication 2, caractérisé en ce que la couche d'enregistrement photopolymérisable formant le relief (B) ou son épaisseur supérieure (B) consiste en
(b1) 20 à 99 % en poids d'au moins un élastomère soluble ou gonflable dans l'eau ou les solvants aqueux, qui sert de liant,
(b2) 0,001 à 10 % en poids d'au moins un inducteur de photopolymérisation,
(b3) 1 à 60 % en poids, d'au moins un monomère photopolymérisable compatible avec le ou les élastomères (b1) et
(b4) 0 à 40 % en poids d'au moins un produit auxiliaire,
et la couche de couverture transparente (C) consiste principalement ou en totalité en polyamides, copolyamides, polyéthylène, copolymères éthylènepropylène, polystyrène, copolymères styrèneacrylonitrile, poly-(méth)acrylates, copolymères éthylène-acétate de vinyle, chlorure de polyvinyle, copolymères chlorure de vinyl-acétate de vinyle, polycarbonates, caoutchoucs de silicones, polyester, polyuréthannes ou cyclocaoutchoucs à haut taux de cyclisation.

8. L'élément d'enregistrement photosensible selon la revendication 2 ou 7, caractérisé en ce que les élastomères (b1) sont des copolymères éthylène-acide (méth)acrylique, poly-(alcanoates d'alcools vinyliques) partiellement ou presque complètement hydrolysés, copolymères greffés alcanoate d'alcool vinylique-oxyde d'alkylène partiellement ou presque complètement hydrolysés, polymères d'alcadiènes maléinisés, polymères d'alcadiènes modifiés à l'état polymère par maléinisation et estérification partielle ou amidation partielle, copolymères d'alcadiènes et d'acides carboxyliques alpha,bêta-insaturés ou copolymères alcadiène-acrylonitrile contenant des groupes carboxyle.

9. L'élément d'enregistrement photosensible selon une des revendications 2, 7 ou 8, caractérisé en ce que les élastomères (b1) sont des copolymères éthylène-acide (méth)acrylique contenant au moins un autre comonomère du groupe des esters vinyliques, des éthers vinyliques, des esters acryliques, des esters méthacryliques, des acrylamides et des méthacrylamides, à l'état polymérisé, et la couche de couverture transparente (C) consiste principalement ou en totalité en un polyamide.

10. Procédé pour la fabrication d'une plaque d'impression flexographique en relief à couche de relief photopolymérisée à partir d'un élément d'enregistrement photosensible contenant un support à dimensions stables (A), une couche d'enregistrement photopolymérisable formant le relief (B), qui consiste elle-même en une seule épaisseur (B) ou en au moins deux épaisseurs individuelles (B), et une couche de couverture transparente (C) adhérant solidement à la surface de (B), par
(1) exposition à la lumière actinique avec formation d'une image de la couche d'enregistrement photopolymérisable formant le relief (B), cette exposition produisant dans la couche d'enregistrement (B) une différence de solubilité entre les régions exposées et les régions non exposées, et
(2) extraction par lavage (développement) de la couche de couverture transparente (C) et des régions non exposées et par conséquent non photopolymérisées de la couche d'enregistrement formant le relief (B) exposée à la lumière avec formation d'une image à l'aide d'un solvant, ce qui provoque la formation de la couche en relief photopolymérisée,
caractérisé en ce que l'on utilise à cet effet un élément d'enregistrement photosensible selon l'une des revendications 1 à 9 et en ce que l'on procède au développement (stade opératoire 2) à l'aide d'une émulsion, en une seule opération.

11. Procédé selon la revendication 10, caractérisé en ce que la couche d'enregistrement photopolymérisable formant le relief (B) comprend au moins deux épaisseurs individuelles (B) ayant des propriétés de solubilité différentes et en ce que, au stade opératoire (2) on extrait par lavage (on développe) à l'aide d'une émulsion, en une seule opération, les régions non exposées d'au moins deux des épaisseurs individuelles (B) à propriétés de solubilité différentes et, en même temps, la couche de couverture transparente (C).

12. Le procédé de la revendication 11, caractérisé en ce que l'on utilise un élément d'enregistrement photosensible dont la couche de couverture transparente (C) et l'épaisseur individuelle (B) placée immédiatement au-dessous de (C) sont solubles ou gonflables dans les solvants organiques.

13. Le procédé de la revendication 11, caractérisé en ce que l'on utilise un élément d'enregistrement photosensible dont la couche de couverture transparente (C) et l'épaisseur individuelle (B) placée immédiatement au-dessous de (C) sont solubles ou gonflables dans l'eau ou les solvants aqueux.

14. Le procédé selon l'une des revendications 10 à 13, caractérisé en ce que l'on utilise une émulsion du type "eau-dans-l'huile" contenant une phase aqueuse en fine dispersion et une phase organique continue, non combustible ou difficilement combustible et/ou à haut point d'ébullition, dans des proportions en volume de 90 : 10 à 10 : 90.

15. Le procédé selon une des revendications 10 à 13, caractérisé en ce que l'on utilise une émulsion du type "huile-dans-l'eau" contenant une phase organique en fine dispersion et une phase aqueuse continue dans un rapport en volume de 90 : 10 à 10 : 90.

16. Le procédé selon la revendication 15, caractérisé en ce que l'on utilise une phase organique non combustible ou difficilement combustible et/ou à haut point d'ébullition.

17. Le procédé de la revendication 14, caractérisé en ce que l'on utilise un élément d'enregistrement photosensible selon une des revendications 3 à 6.

18. Le procédé selon la revendication 15, caractérisé en ce que l'on utilise un élément d'enregistrement photosensible selon une des revendications 2 à 7 à 9.

19. Le procédé selon une des revendications 15 à 18, caractérisé en ce que la phase organique consiste en totalité ou en partie en hydrocarbures chlorés, hydrocarbures aromatiques, hydrocarbures cycliques et/ou acycliques saturés et/ou insaturés, distillats de pétrole, fractions de pétrole hydrogénées et/ou leurs mélanges.
